# EUROPEAN PATENT APPLICATION

(11) **EP 4 550 166 A1**
(43) Date of publication of application: **07.05.2025**
(21) Application number: 23830459.6
(22) Date of filing: 29.06.2023
(51) Int. Cl.: G06F 16/21

(54) **DIGITAL TWINNING METHOD, APPARATUS AND DEVICE FOR FULL LIFE CYCLE OF THING**

(30) Priority: 30.06.2022 CN 202210767668; 30.06.2022 CN 202210768095
(71) Applicant: Beijing Wellintech Co., Ltd., Beijing 100086 (CN)
(72) Inventor: LIN, Wei, Beijing 100086 (CN)
(74) Representative: Cabinet Nony
(86) International application number: PCT/CN2023/104172
(87) International publication number: WO 2024/002295

(57) **Abstract**

The present application provides a digital twinning method, apparatus and device for a full life cycle of a thing. The method comprises: creating a data model of a thing, the structure of the data model being an attribute parameter set of the thing; obtaining the current state, historical state and planned state of a same target thing; and performing digital twinning on the basis of the data model and the current state of the target thing to obtain a real-time thing object, performing digital twinning on the basis of the data model and the historical state of the target thing to obtain a historical thing object, and performing digital twinning on the basis of the data model and the planned state of the target thing to obtain a planned thing object, wherein the thing is a physical entity or an event. The method solves the problem that two or more models having the same structure and different parameter values cannot be distinguished in a modeling stage; moreover, digital twinning can be performed on the state of the entity object in different time periods in the future, thereby implementing data modeling of the full life cycle of the event, and providing a basis for the construction of a complex model.

## Description

### Cross Reference to Related Application

The present disclosure claims the priority of the Chinese patent application No. 202210767668.3 filed to the China National Intellectual Property Administration on June 30, 2022 and entitled "DIGITAL TWINNING METHOD, APPARATUS AND DEVICE FOR FULL LIFE CYCLE OF PHYSICAL ENTITY", the entire content of which is incorporated by reference in the present disclosure; the present disclosure claims the priority of the Chinese patent application No. 202210768095.6 filed to the China National Intellectual Property Administration on June 30, 2022 and entitled "DIGITAL TWINNING METHOD, APPARATUS AND DEVICE FOR FULL LIFE CYCLE OF EVENT", the entire content of which is incorporated by reference in the present disclosure.

### Technical Field

The present disclosure relates to the technical fields of computers and the Internet of Things, and particular to a digital twinning method, an apparatus and a device for a full life cycle of a thing.

### Background

The digital twinning is not only a mirror of the physical world, but also needs to accept real-time information from the physical world, and in turn drive the physical world in real time, and evolve into a prophet, prophet, or even a super body of the physical world. The growth and development of the digital twinning has gone through several processes such as digitization, interaction, foresight, foresight and co-intelligence. Here, the "digitization" is the process of digitizing the physical world. This process requires expressing physical objects into digital models that can be identified by computers and networks. Modeling technology is one of the core technologies of digitalization, such as surveying and scanning, geometric modeling, grid modeling, system modeling, process modeling, organizational modeling and other technologies. The current digital twinning model can be generally divided into general models and professional model.

Here, although the professional model is highly targeted, it is not universal, has poor openness and compatibility, and cannot interact and integrate. From the data dimension, current data modeling technology only models data for real-time objects, and cannot achieve data modeling of the full life cycle of objects. At the same time, it is usually a model-to-object model, that is, different models are established for different objects. Therefore, when targeting multiple objects with the same structure but different specific parameters, different models need to be established for the multiple objects respectively. This results in high complexity of the model and requires more resources.

### Summary

The present disclosure provides a digital twinning method, an apparatus and a device for a full life cycle of a thing, which is used to solve the problem in the related art that when targeting multiple objects with the same structure but different specific parameters, different models need to be established for the multiple objects respectively, and the problem in the related art that data modeling is only performed on real-time events that are currently occurring, which cannot realize data modeling of the full life cycle of the events.

In a first aspect, the present disclosure provides a digital twinning method for a full life cycle of a thing, including:
creating a data model of the thing, where a structure of the data model is an attribute parameter set of the thing;
obtaining a current state, a historical state and a planned state of a same target thing;
performing digital twinning based on the data model and the current state of the target thing to obtain a real-time thing object, performing digital twinning based on the data model and the historical state of the target thing to obtain a historical thing object, and performing digital twinning based on the data model and the planned state of the target thing to obtain a planned thing object.

Optionally, the thing is a physical entity or an event.

Optionally, the attribute parameter set of the thing includes:
spatial attributes configured for recording a space of the physical entity or a space where the event occurs.

Optionally, the creating the data model of the thing includes:
obtaining the structure of the data model by determining the attribute parameter set of the thing, where attribute parameters in the attribute parameter set of the thing include an attribute name and a data type;
performing at least one attribute parameter initialization on the structure of the data model to obtain at least one set of predefined data initial values corresponding to the structure of the data model.

Optionally, when the thing is a physical entity, the performing digital twinning based on the data model and the current state of the target thing to obtain the real-time thing object, performing digital twinning based on the data model and the historical state of the target thing to obtain the historical thing object, and performing digital twinning based on the data model and the planned state of the target thing to obtain the planned thing object, include:
determining a set of predefined data initial values corresponding to a target physical entity, and replacing the determined set of predefined data initial values with attribute parameter values corresponding to a current state of the target physical entity to obtain a real-time physical entity object;
determining a set of predefined data initial values corresponding to a target physical entity, and replacing the determined set of predefined data initial values with attribute parameter values corresponding to a historical state of the target physical entity to obtain a historical physical entity object;
determining a set of predefined data initial values corresponding to a target physical entity, and replacing the determined set of predefined data initial values with attribute parameter values corresponding to a planned state of the target physical entity to obtain a planned physical entity object.

Optionally, when the thing is an event, the performing digital twinning based on the data model and the current state of the target thing to obtain the real-time thing object, performing digital twinning based on the data model and the historical state of the target thing to obtain the historical thing object, and performing digital twinning based on the data model and the planned state of the target thing to obtain the planned thing object, include:
determining a set of predefined data initial values corresponding to classification of a target event that is occurring, and replacing the determined set of predefined data initial values with attribute parameter values of the target event that is occurring to obtain a real-time event object;
determining a set of predefined data initial values corresponding to classification of a target event that has occurred in history, and replacing the determined set of predefined data initial values with attribute parameter values of the target event that has occurred in history to obtain a historical event object;
determining a set of predefined data initial values corresponding to classification of a target event planned to occur, and replacing the determined set of predefined data initial values with attribute parameter values of the target event planned to occur to obtain a planned event object.

Optionally, when the thing is a physical entity, the attribute parameter set of the thing includes a time attribute, where,
the time attribute of a real-time physical entity object is used for recording a current moment when the physical entity changes or a latest moment when the physical entity changes;
the time attribute of a historical physical entity object is used for recording every time the physical entity changes in history;
the time attribute of a planned physical entity object is used for recording a moment when the physical entity plans to change and a duration of the change.

Optionally, when the thing is an event, the attribute parameter set of the thing includes a time attribute, where,
the time attribute of a real-time event object is used for recording a start time of the event and a duration of the event;
the time attribute of a historical event object is used for recording the start time of the event and an end time of the event, or is used for recording the start time of the event and the duration of the event;
the time attribute of a planned event object is used for recording the start time of the event and the end time of the event, or is used for recording the start time of the event and the duration of the event.

Optionally, the method further includes:
recording an attribute parameter value of the obtained real-time thing object to obtain a real-time thing object record of a corresponding thing;
recording an attribute parameter value of the obtained historical thing object to obtain a historical thing object record of a corresponding thing;
recording an attribute parameter value of the obtained planned thing object to obtain a planned thing object record of a corresponding thing;
where a thing object identifier of the real-time thing object record, a thing object identifier of the historical thing object record, and a thing object identifier of the planned thing object record of the same thing are the same.

Optionally, when the thing is a physical entity, the recording the attribute parameter value of the obtained historical thing object to obtain the historical thing object record of the corresponding thing includes:
determining that a current state of a target physical entity changes, obtaining a historical state of the target physical entity according to the changed state of the target physical entity, and determining and recording an attribute parameter value of a historical physical entity object to obtain a historical physical entity object record corresponding to the physical entity; or
determining and recording an attribute parameter value of a historical physical entity object according to a historical state of a target physical entity predefined by a user to obtain a historical physical entity object record corresponding to the physical entity.

Optionally, when the thing is an event, the recording the attribute parameter value of the obtained historical thing object to obtain the historical thing object record of the corresponding thing includes:
determining that a target event that is occurring ends, and recording an attribute parameter value of a target event to obtain a historical event record of the target event; or
obtaining a historical event object record of a target event according to an attribute parameter value of the target event that has occurred in history predefined by a user.

Optionally, when the thing is a physical entity, the recording the attribute parameter value of the obtained planned thing object to obtain the planned thing object record of the corresponding thing includes:
determining and recording an attribute parameter value of a planned physical entity object according to a planned state of a target physical entity predefined by a user to obtain a planned physical entity object record corresponding to the physical entity.

Optionally, when the thing is an event, the recording the attribute parameter value of the obtained planned thing object to obtain the planned thing object record of the corresponding thing includes:
obtaining a planned event object record corresponding to a target event according to an attribute parameter value of the target event planned to occur predefined by a user.

Optionally, when the thing is a physical entity, the method further includes:
after replacing the determined set of predefined data initial values with the attribute parameter values corresponding to the current state of the target physical entity, recording a set of attribute parameter values obtained after the replacement to obtain a real-time physical entity object record corresponding to the physical entity;
after replacing the determined set of predefined data initial values with the attribute parameter values corresponding to the historical state of the target physical entity, recording a set of attribute parameter values obtained after the replacement to obtain a historical physical entity object record corresponding to the physical entity;
after replacing the determined set of predefined data initial values with the attribute parameter values corresponding to the planned state of the target physical entity, recording a set of attribute parameter values obtained after the replacement to obtain a planned physical entity object record corresponding to the physical entity;
where a physical entity object identifier of the real-time physical entity object record, a physical entity object identifier of the historical physical entity object record, and a physical entity object identifier of the planned physical entity object record of the same physical entity are the same.

Optionally, when the thing is an event, the method further includes:
after replacing the determined set of predefined data initial values with the attribute parameter values of the target event that is occurring, recording a set of attribute parameter values obtained after the replacement to obtain a real-time event object record corresponding to the target event;
after replacing the determined set of predefined data initial values with the attribute parameter values of the target event that has occurred in history, recording a set of attribute parameter values obtained after the replacement to obtain a historical event object record corresponding to the target event;
after replacing the determined set of predefined data initial values with the attribute parameter values of the target event planned to occur, recording a set of attribute parameter values obtained after the replacement to obtain a planned event object record corresponding to the target event.

Optionally, the method further includes:
determining the attribute parameter values corresponding to the historical state of the target physical entity according to a current state of the target physical entity after the change, or according to a historical state of the target physical entity predefined by a user;
determining the attribute parameter values corresponding to the planned state of the target physical entity according to a planned state of the target physical entity predefined by the user.

Optionally, the method further includes:
determining the attribute parameter values of the target event that has occurred in history according to attribute parameter values at the end of the target event that is occurring, or according to attribute parameter values predefined by a user;
determining the attribute parameter values of the target event planned to occur according to the attribute parameter values predefined by the user.

Optionally, the attribute parameter set of the thing includes the following attribute parameters:
a thing data model identifier, used for uniquely identifying the data model of the corresponding thing;
a thing object identifier, used for uniquely identifying the corresponding thing;
a predefined identifier of a thing data model, used for uniquely identifying a set of predefined data initial values of a corresponding thing data model.

Optionally, when the thing is the physical entity, the spatial attributes further include at least one of the following attributes:
a location attribute, used for recording a spatial location where the physical entity is located;
a shape attribute, used for recording a shape of the physical entity.

Optionally, when the thing is the event, the spatial attributes include at least one of a spatial location and a spatial range.

Optionally, the spatial location is described as an offset of the physical entity relative to a spatial location of other associated physical entity, or as another object entity within a spatial location of other associated physical entity.

Optionally, when the thing is an event, a historical event object record and a real-time event object record of a same target event are not recorded at the same time.

In a second aspect, the present disclosure provides a physical entity subscription method, including:
creating a data model of a thing, where a structure of the data model is an attribute parameter set of the thing;
obtaining a current state, a historical state and a planned state of a same target thing;
performing digital twinning based on the data model and the current state of the target thing to obtain a real-time thing object, performing digital twinning based on the data model and the historical state of the target thing to obtain a historical thing object, and performing digital twinning based on the data model and the planned state of the target thing to obtain a planned thing object;
generating a subscription item according to a subscription request of the thing, and based on determining that a condition that triggers generation of subscription information is met, generating corresponding subscription information according to the subscription item during digital twinning of a full life cycle of the thing.

Optionally, the thing is a physical entity or an event.

Optionally, the based on determining that the condition that triggers the generation of subscription information is met, generating the corresponding subscription information according to the subscription item, includes:
determining that the condition that triggers the generation of subscription information is met when at least one set of predefined data initial values corresponding to the structure of the data model is determined to be created, modified or deleted;
querying at least one set of predefined data initial values corresponding to the structure of the data model for data whose attribute parameters include a thing object identifier and satisfy a filtering condition according to the thing object identifier and the filtering condition in the subscription item to obtain the subscription information matching the subscription request.

Optionally, the based on determining that the condition that triggers the generation of subscription information is met, generating the corresponding subscription information according to the subscription item, includes:
determining the condition that triggers the generation of subscription information is met when a planned thing object is determined to be created, modified or deleted;
when attribute parameters of the planned thing object that is determined to be created, modified or deleted include a thing identifier in the subscription item, querying data, in the planned thing object that is determined to be created, modified or deleted, that satisfies the filtering condition in the subscription item to obtain the subscription information matching the subscription request.

Optionally, the based on determining that the condition that triggers the generation of subscription information is met, generating the corresponding subscription information according to the subscription item, includes:
determining that the condition that triggers the generation of subscription information is met when a real-time thing object instantiated by a planned thing object is determined to be created, or when a real-time thing object is determined to be deleted or modified;
when attribute parameters of the real-time thing object that is determined to be created, modified or deleted include a thing identifier in the subscription item, querying data, in the real-time thing object that is determined to be created, modified or deleted, that satisfies the filtering condition in the subscription item to obtain the subscription information matching the subscription request.

Optionally, when the thing is a physical entity, the based on determining that the condition that triggers the generation of subscription information is met, generating the corresponding subscription information according to the subscription item, includes:
determining that the condition that triggers the generation of subscription information is met when a real-time physical entity object is determined to be modified to generate a historical physical entity object;
when attribute parameters of the generated historical physical entity object include a physical entity identifier in the subscription item, querying data, in the generated historical physical entity object, that satisfies the filtering condition in the subscription item to obtain the subscription information matching the subscription request.

Optionally, when the thing is an event, the based on determining that the condition that triggers the generation of subscription information is met, generating the corresponding subscription information according to the subscription item, includes:
determining that the condition that triggers the generation of subscription information is met when a historical event object generated based on an end of a real-time event is determined to be added;
when attribute parameters of the added historical event object include an event object identifier in the subscription item, querying data, in the generated historical event object, that satisfies the filtering condition in the subscription item to obtain the subscription information matching the subscription request.

Optionally, when the thing is an event, the based on determining that the condition that triggers the generation of subscription information is met, generating the corresponding subscription information according to the subscription item, includes:
determining that the condition that triggers the generation of subscription information is met when an event object is determined to be created, modified or deleted, where the event object includes a planned event object, a real-time event object and a historical event object;
when time attributes of the event object that is determined to be created, modified or deleted belong to a time range in the subscription item, querying data, in the event object that is determined to be created, modified or deleted, that satisfies the filtering condition in the subscription item to obtain the subscription information matching the subscription request.

Optionally, when the thing is an event, the based on determining that the condition that triggers the generation of subscription information is met, generating the corresponding subscription information according to the subscription item, includes:
determining that the condition that triggers the generation of subscription information is met when an event object is determined to be created, modified or deleted, where the event object includes a planned event object, a real-time event object and a historical event object;
when a generation entity to which the event object that is determined to be created, modified or deleted belongs is consistent with an entity identifier in the subscription item, and a spatial range of the entity to which the entity belongs is consistent with a spatial range in the subscription item, querying data, in the event object that is determined to be created, modified or deleted, that satisfies the filtering condition in the subscription item to obtain the subscription information matching the subscription request.

Optionally, when the thing is the physical entity, the method further includes:
receiving a physical entity query request, where the physical entity query request includes a physical entity object identifier and a filtering field;
determining the subscription information obtained by the subscription item containing the physical entity object identifier, filtering the determined subscription information according to the filtering field to obtain a query result.

In a third aspect, the present disclosure provides a digital twinning apparatus for a full life cycle of a thing, including:
a creation module, configured to create a data model of the thing, where a structure of the data model is an attribute parameter set of the thing;
an obtaining module, configured to obtain a current state, a historical state and a planned state of a same target thing;
an object generation module, configured to perform digital twinning based on the data model and the current state of the target thing to obtain a real-time thing object, perform digital twinning based on the data model and the historical state of the target thing to obtain a historical thing object, and perform digital twinning based on the data model and the planned state of the target thing to obtain a planned thing object.

In a fourth aspect, the present disclosure provides a thing subscription device, including:
a creation module, configured to create a data model of the thing, where a structure of the data model is an attribute parameter set of the thing;
an obtaining module, configured to obtain a current state, a historical state and a planned state of a same target thing;
an object generation module, configured to perform digital twinning based on the data model and the current state of the target thing to obtain a real-time thing object, perform digital twinning based on the data model and the historical state of the target thing to obtain a historical thing object, and perform digital twinning based on the data model and the planned state of the target thing to obtain a planned thing object;
a subscription module, configured to generate a subscription item according to a subscription request of the thing, and based on determining that a condition that triggers generation of subscription information is met, generate corresponding subscription information according to the subscription item during digital twinning of a full life cycle of the thing.

In a fifth aspect, the present disclosure provides a digital twinning apparatus for a full life cycle of a thing, including at least one processor; and a memory in communication connection with the at least one processor; where the memory stores instructions executed by the at least one processor, and the instructions are executed by the at least one processor to cause the at least one processor to perform the method according to the first aspect.

In a sixth aspect, the present disclosure provides a thing subscription device, including at least one processor; and a memory in communication connection with the at least one processor; where the memory stores instructions executed by the at least one processor, and the instructions are executed by the at least one processor to cause the at least one processor to perform the method according to the second aspect.

In a seventh aspect, the present disclosure provides a computer storage medium, storing computer programs, where the computer programs are configured to cause a computer to execute the method according to the first aspect or the second aspect.

The technical solutions provided by embodiments of the present disclosure bring at least the following beneficial effects:
a digital twinning method, an apparatus and a device for a full life cycle of a thing provided in the present disclosure are intended to standardize the generation of digital twinning data in the related art, to achieve synergy of digital twins, to reduce the cost of development of models, as well as to achieve data modeling of the full life cycle of the thing, and to reduce the impact of subsequently utilized connections and services.

### Brief Description of Figures

In order to more clearly illustrate the technical solutions in the embodiments of the present disclosure, a brief introduction will be given below to the drawings needed to be used in the description of the embodiments. Obviously, the drawings in the following description are only some embodiments of the present disclosure. Those of ordinary skill in the art can also obtain other drawings based on these drawings without exerting any creative effort.
FIG. 1 is a flow chart of a digital twinning method for a full life cycle of a thing provided by embodiments of the present disclosure.
FIG. 2 is a flow chart of a digital twinning method for a full life cycle of a physical entity provided by embodiments of the present disclosure.
FIG. 3 is a schematic diagram of a digital twinning process of a full life cycle of a physical entity provided by embodiments of the present disclosure.
FIG. 4 is a flow chart of a physical entity subscription method provided by embodiments of the present disclosure.
FIG. 5 is a schematic diagram of a digital twinning apparatus for a full life cycle of a physical entity provided by embodiments of the present disclosure.
FIG. 6 is a schematic diagram of a physical entity subscription device provided by embodiments of the present disclosure.
FIG. 7 is a schematic flow chart of a digital twinning method for a full life cycle of an event according to embodiments of the present disclosure.
FIG. 8 is a schematic diagram of constructing an event object record according to embodiments of the present disclosure.
FIG. 9 is a schematic diagram of another constructing an event object record according to embodiments of the present disclosure.
FIG. 10 is a schematic flow chart of an event subscription method according to embodiments of the present disclosure.
FIG. 11 is a schematic diagram of a digital twinning device for a full life cycle of an event according to embodiments of the present disclosure.
FIG. 12 is a schematic diagram of an event subscription device according to embodiments of the present disclosure.
FIG. 13 is a schematic diagram of a digital twinning device for a full life cycle of a thing provided by embodiments of the present disclosure.
FIG. 14 is a schematic diagram of a thing subscription device provided by embodiments of the present disclosure.

### Detailed Description

In order to make the purpose, technical solutions and advantages of the present disclosure clearer, the present disclosure will be described in further detail below in conjunction with the accompanying drawings.

The scenarios described in the embodiments of the present disclosure are for the purpose of more clearly explaining the technical solutions of the embodiments of the present disclosure, and do not constitute a limitation on the technical solutions provided by the embodiments of the present disclosure. Persons of ordinary skill in the art will know that with the emergence of new application scenarios, the technical solutions provided by the embodiments of the present disclosure are also applicable to similar technical problems. Here, in the description of the present disclosure, unless otherwise stated, the meaning of "plurality" or "multiple" is two or more.

It should be noted that the terms "first", "second", etc., in the description and claims of the present disclosure and the above-mentioned drawings are used to distinguish similar objects and are not necessarily used to describe a specific order or sequence. It is to be understood that the data so used are interchangeable under appropriate circumstances so that the embodiments of the present disclosure described herein can be practiced in sequences other than those illustrated or described herein. The implementations described in the following exemplary embodiments do not represent all implementations consistent with the present disclosure. Rather, they are merely embodiments of apparatus and methods consistent with aspects of the present disclosure as detailed in the appended claims. Based on the embodiments in the present disclosure, all other embodiments obtained by those of ordinary skill in the art without creative efforts fall within the scope of protection of the present disclosure.

"Digitalization" is the process of digitizing the physical world. This process requires expressing physical objects into digital models that can be recognized by computers and networks. Modeling technology is one of the core technologies of digitalization, such as surveying and scanning, geometric modeling, grid modeling, system modeling, process modeling, organizational modeling and other technologies. If a high-fidelity digital virtual model is need to be established, all aspects of a thing should be described. For example, to twinning a physical entity, it needs to truly reproduce the geometry, attributes, behaviors, rules, etc., of the physical entity. Therefore, a complete digital twinning model should be multi-dimensional.

The current digital twinning model can be generally divided into two modes: general model and professional model. The professional model and tools have the advantage of being targeted, but the disadvantage is that they are not universal, have poor openness and compatibility, and cannot interact and integrate. From the perspective of data alone, the current data modeling technology for the physical entity has the problem of being unable to distinguish models with the same structure but different parameter values. Moreover, most of the current object full-cycle data only include real-time and historical data, lack of management of prenatal planned data. At the same time, the current data modeling technology for events only involves event data in a certain state. For example, it only models data for real-time events that are currently occurring, and cannot achieve data modeling of the full life cycle of the events, which can affect subsequent utilization of connections and services.

Based on the above problems, the present disclosure provides a digital twinning method, apparatus and device for the full life cycle of the thing, aiming to standardize the digital twinning data generated in the related art, realize the collaboration of digital twins, reduce the development cost of the model and realize data modeling of the full life cycle of the thing.

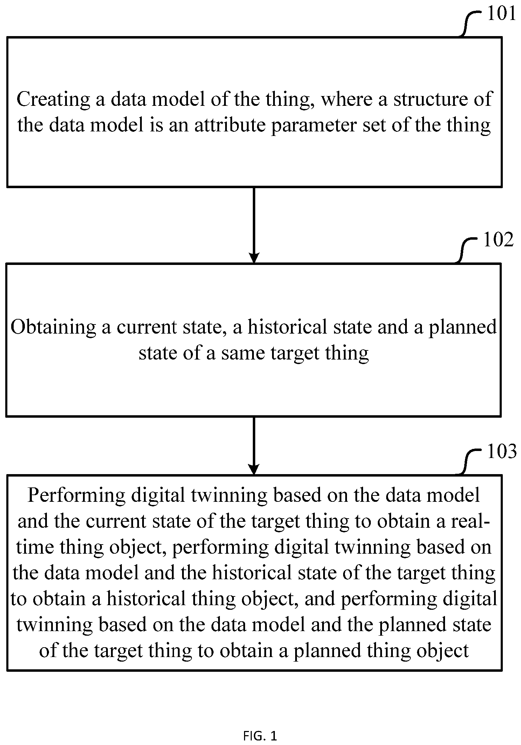

FIG. 1 is a schematic flow chart of a digital twinning method for the full life cycle of the thing provided by embodiments of the present disclosure. As shown in FIG. 1, the embodiments of the present disclosure provide a digital twinning method for the full life cycle of the thing, including the following steps.

Step 101: creating a data model of the thing, where a structure of the data model is an attribute parameter set of the thing.

Step 102: obtaining a current state, a historical state and a planned state of a same target thing.

Step 103: performing digital twinning based on the data model and the current state of the target thing to obtain a real-time thing object, performing digital twinning based on the data model and the historical state of the target thing to obtain a historical thing object, and performing digital twinning based on the data model and the planned state of the target thing to obtain a planned thing object.

In one or more embodiments, the thing is a physical entity or an event.

When the thing is the physical entity, a digital twinning method for the full life cycle of the physical entity provided by the embodiments of the present disclosure will be described below.

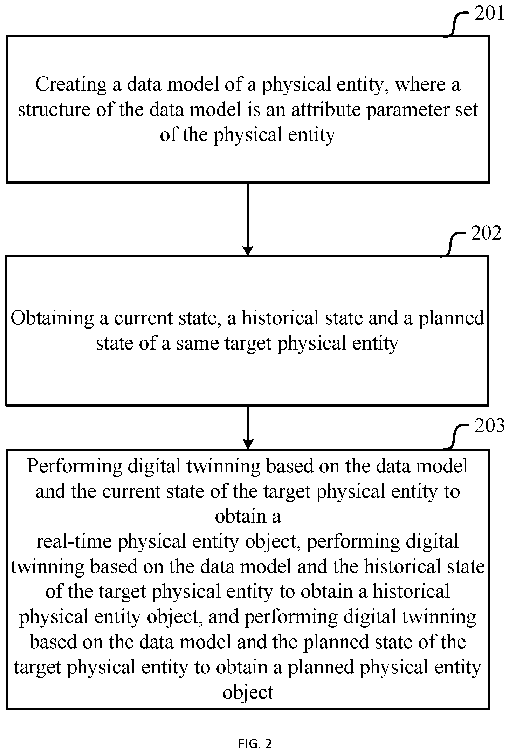

FIG. 2 is a schematic flow chart of a digital twinning method for the full life cycle of the physical entity provided by embodiments of the present disclosure. As shown in FIG. 2, the embodiments of the present disclosure provide a digital twinning method for the full life cycle of the physical entity, including the following steps.

Step 201: creating a data model of a physical entity, where a structure of the data model is an attribute parameter set of the physical entity.

Step 202: obtaining a current state, a historical state and a planned state of a same target physical entity.

Step 203: performing digital twinning based on the data model and the current state of the target physical entity to obtain a real-time physical entity object, performing digital twinning based on the data model and the historical state of the target physical entity to obtain a historical physical entity object, and performing digital twinning based on the data model and the planned state of the target physical entity to obtain a planned physical entity object.

When creating the data model of the physical entity, attribute parameters of the physical entity are obtained and the set of attribute parameters of the physical entity is determined, that is, obtaining the data model of the physical entity.

Here, the attribute parameters of the physical entity include an attribute name(s) and a data type(s).

After creating the data model of the physical entity, the current state, historical state, and planned state corresponding to the target physical entity at the current moment, a historical moment, and a future moment respectively are obtained, where the state refers to a specific value of each attribute parameter in the attribute parameter set at a corresponding moment where the target physical entity is located.

Then, based on the above created data model, as well as the current state, historical state and planned state of the target physical entity, digital twins are performed respectively to obtain a real-time physical entity object, a historical physical entity object and a planned physical entity object corresponding to the current state, historical state and planned state respectively.

As an optional embodiment, after creating the data model of the physical entity, the data model of the physical entity can be further predefined to obtain an initial value of the attribute parameter set corresponding to the structural model of the physical entity, where a structural model corresponds to at least one predefined data initial value. The above predefined data initial value refers to a specific initial value corresponding to at least one attribute parameter in the structural model.

The above-mentioned initial value of the predefined data can be set manually by the user according to the needs, or the attribute parameter value of the physical entity at a certain moment can be used as the initial value of the predefined data.

As an optional embodiment, the creating the data model of the physical entity, includes:
obtaining the structure of the data model by determining the attribute parameter set of the physical entity, where attribute parameters in the attribute parameter set of the physical entity include an attribute name and a data type;
performing at least one attribute parameter initialization on the structure of the data model to obtain at least one set of predefined data initial values corresponding to the structure of the data model.

After creating the data model of the physical entity, the current state, historical state, and planned state corresponding to the target physical entity at the current moment, the historical moment, and the future moment respectively are obtained, where the state refers to a specific value of each attribute parameter in the attribute parameter set at a corresponding moment where the target physical entity is located.

Then, the obtained attribute parameter values corresponding to the states of the target physical entity at each time are used to replace the predefined data initial values in the above-mentioned created data model to obtain the corresponding twinning objects.

As an optional embodiment, the performing digital twinning based on the data model and the current state of the target physical entity to obtain the real-time physical entity object, performing digital twinning based on the data model and the historical state of the target physical entity to obtain the historical physical entity object, and performing digital twinning based on the data model and the planned state of the target physical entity to obtain the planned physical entity object, includes:
determining a set of predefined data initial values corresponding to a target physical entity, and replacing the determined set of predefined data initial values with attribute parameter values corresponding to a current state of the target physical entity to obtain a real-time physical entity object;
determining a set of predefined data initial values corresponding to a target physical entity, and replacing the determined set of predefined data initial values with attribute parameter values corresponding to a historical state of the target physical entity to obtain a historical physical entity object;
determining a set of predefined data initial values corresponding to a target physical entity, and replacing the determined set of predefined data initial values with attribute parameter values corresponding to a planned state of the target physical entity to obtain a planned physical entity object.

As an optional embodiment, the attribute parameter set of the physical entity includes the following attribute parameters:
a physical entity data model identifier, used for uniquely identifying the data model of the corresponding physical entity;
a physical entity object identifier, used for uniquely identifying the corresponding physical entity;
a predefined identifier of a physical entity data model, used for uniquely identifying a set of predefined data initial values of a corresponding physical entity data model.

In some embodiments, the physical entity object identifiers of the real-time physical entity object, the historical physical entity object and the planned physical entity object of the same physical entity are the same, indicating that they are twinning objects of the same physical entity in different tenses.

As an optional embodiment, the attribute parameter set of the above physical entity includes a time attribute.

The time attribute of the above-mentioned real-time physical entity object is used for recording a current moment when the physical entity changes or the latest moment when the physical entity changes.

The time attribute of the above historical physical entity object is used for recording every time the physical entity changes in history.

The time attribute of the above planned physical entity object is used for recording the moment when the physical entity plan changes and the duration of the change.

As an optional embodiment, the attribute parameter set of the above physical entity includes:
a spatial attribute(s), used for recording the space of the physical entity.

Here, the spatial attributes of the above-mentioned real-time physical entity object are used for recording the space to which the physical entity currently belongs; the spatial attributes of the above-mentioned historical physical entity object are used for recording the space to which the physical entity belongs in the past; and the spatial attributes of the above-mentioned planned physical entity object are used for recording the space to which the physical entity belongs in the future.

The attribute parameter set of the above-mentioned physical entity also includes a parent attribute. The above-mentioned parent attribute is used for recording that the physical entity is a parent physical entity, or to record that the physical entity is a child physical entity and a physical entity object identifier of the parent physical entity to which the child physical entity belongs.

The above spatial attributes include a parent space. The parent space of the physical entity object refers to the space where its parent physical entity object is located. The parent-child relationship between the above physical entity objects refers to a spatial inclusion relationship between the physical entity objects. If there is a corresponding parent physical entity object of the physical entity object, the space of the parent physical entity object is the space to which the physical entity object belongs. If the space to which the parent physical entity object belongs moves, the above-mentioned space of the physical entity object will also move accordingly.

Here, the above-mentioned spatial attributes also include at least one of the following attributes:
a location attribute(s), used for recording a spatial location of a physical entity;
a shape attribute(s), used for recording a shape of a physical entity.

As an optional embodiment, the above spatial location is described as an offset of the physical entity relative to a spatial location of other associated physical entity, or as another object entity within a spatial location of the above other associated physical entity.

In some embodiments, the offset of the above-mentioned physical entity relative to the spatial location of the other associated physical entity refers to a location offset of the physical entity within the spatial location of its parent physical entity. For example, the parent physical entity of the keyboard is a research and development office, its spatial location can be described as a coordinate within the office.

Another physical entity in the spatial location where the other associated physical entities are located refers to another physical entity in the spatial location where the parent physical entity of the physical entity is located. For example, the parent physical entity of the keyboard is the research and development office, and there is a desk (another child physical entity of the parent physical entity) in the office, its spatial location can be described as a desk.

In some embodiments, the digital twinning method for the full life cycle of the physical entity provided by the embodiments of the present disclosure also includes generating physical entity object records at respective moments. The specific process is to construct a data model of the physical entity and twinning a physical entity object based on the data model of the physical entity, or construct a data model of the physical entity, predefine the data model of the physical entity, and twinning the physical entity object based on the predefined data model of the physical entity. The methods of generating physical entity object records in the embodiments also include the following two methods.

Method 1: recording attribute parameter values of physical entity objects at respective moments to obtain their corresponding physical entity object records.

As an optional embodiment, in the embodiments of the present disclosure, generating the physical entity object records at respective moment, includes:
recording an attribute parameter value of the obtained real-time physical entity object to obtain a real-time physical entity object record corresponding to the physical entity;
recording an attribute parameter value of the obtained historical physical entity object to obtain a historical physical entity object record corresponding to the physical entity;
recording an attribute parameter value of the obtained planned physical entity object to obtain a planned physical entity object record corresponding to the physical entity.

Here, physical entity object identifiers of the real-time physical entity object record, the historical physical entity object record, and the planned physical entity object record of the same physical entity are the same.

As an optional embodiment, the recording the attribute parameter value of the obtained historical physical entity object to obtain the historical physical entity object record corresponding to the physical entity, includes:
determining that a current state of a target physical entity changes, obtaining a historical state of the target physical entity according to the changed state of the target physical entity, and determining and recording an attribute parameter value of a historical physical entity object to obtain a historical physical entity object record corresponding to the physical entity; or
determining and recording an attribute parameter value of a historical physical entity object according to a historical state of a target physical entity predefined by a user to obtain a historical physical entity object record corresponding to the physical entity.

The time attribute of the above historical physical entity object record is the moment when the target physical entity changed in the past. Therefore, multiple historical physical entity object records can represent the state of the target physical entity every time it changed in the past.

As an optional embodiment, the recording the attribute parameter value of the obtained planned physical entity object to obtain the planned physical entity object record corresponding to the physical entity, includes:
determining and recording an attribute parameter value of a planned physical entity object according to a planned state of a target physical entity predefined by a user to obtain a planned physical entity object record corresponding to the physical entity.

The time attribute of the above-mentioned planned physical entity object record is a certain moment in the future, or a certain moment in the future and duration. The above-mentioned planned physical entity object record can represent the state of the target physical entity within a duration starting from a certain moment in the future.

Method 2: using attribute parameter values of a physical entity object at each respective moments to replace predefined data initial values to obtain a physical entity object record corresponding to the physical entity object.

As an optional embodiment, in the embodiments of the present disclosure, generating physical entity object records at respective moments, includes:
after replacing the determined set of predefined data initial values with the attribute parameter values corresponding to the current state of the target physical entity, recording a set of attribute parameter values obtained after the replacement to obtain a real-time physical entity object record corresponding to the physical entity;
after replacing the determined set of predefined data initial values with the attribute parameter values corresponding to the historical state of the target physical entity, recording a set of attribute parameter values obtained after the replacement to obtain a historical physical entity object record corresponding to the physical entity;
after replacing the determined set of predefined data initial values with the attribute parameter values corresponding to the planned state of the target physical entity, recording a set of attribute parameter values obtained after the replacement to obtain a planned physical entity object record corresponding to the physical entity.

Here, the physical entity object identifiers of the real-time physical entity object record, the historical physical entity object record, and the planned physical entity object record of the same physical entity are the same.

As an optional embodiment, the attribute parameter value corresponding to the historical state of the target physical entity is determined based on the current state of the target physical entity after the change, or determined based on the historical state of the target physical entity predefined by the user.

The attribute parameter values corresponding to the planned state of the target physical entity are determined based on the planned state of the target physical entity predefined by the user.

In some embodiments, when the state of the physical entity changes, a historical physical entity object record corresponding to the same physical entity object identifier can be automatically stored.

It should be noted that when performing digital twins, there is only one twinning object for the same physical entity, that is, the real-time physical entity object. The state change of the real-time physical entity object will generate a corresponding historical physical entity object record, and its predefined future state will be generate a corresponding planned physical entity object record.

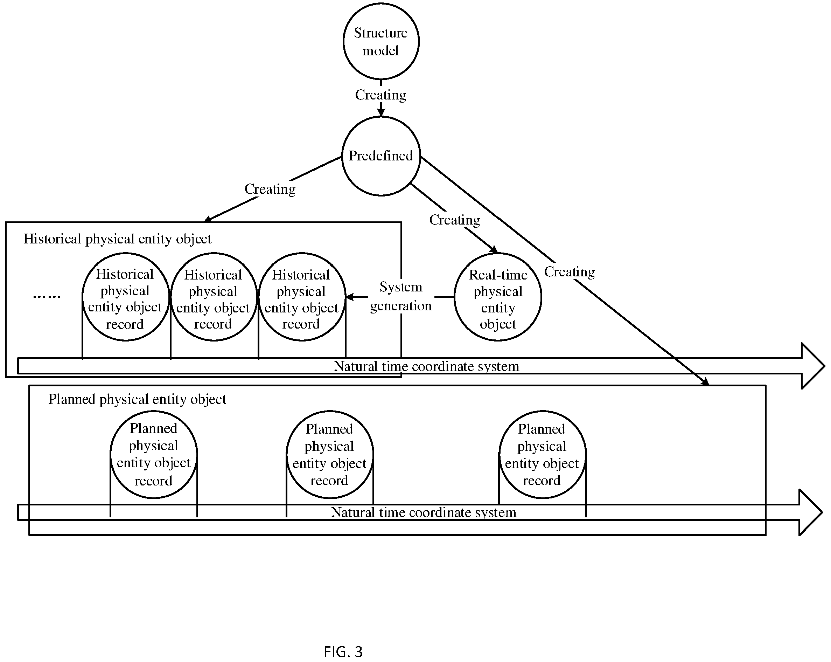

FIG. 3 is a schematic diagram of a digital twinning process for the full life cycle of a physical entity provided by embodiments of the present disclosure. The following is a detailed description of the digital twinning method for the full life cycle of a physical entity provided by embodiments of the present disclosure in conjunction with FIG. 3, where the predefined data initial value is simply called predefinition.

First, a data model is created for the physical entity. Specifically, the data model includes a structural model and predefinition. The structural model contains at least one attribute parameter of the physical entity. Taking tires as an example, attribute parameters of the tires include a tire width, an aspect ratio, a hub diameter, a load coefficient, and a speed coefficient, then the structural model needs to contain at least one of the attributes. one attribute has at least an attribute name and a data type, the structural model of the tire can be created, as shown below:

```
     Model_Tire//tire model
     {
     Float tire width;
     Float aspect ratio;
     Float rim diameter;
     Int load coefficient;
     String speed identifier;
     Bool is it good;
     } ID="M1";
```

After creating the structural model, it is necessary to establish a predefinition corresponding to the structural model. Here, a structural model corresponds to at least one predefinition; and the predefinition records at least a specific value of one attribute parameter of the corresponding structural model. In other words, the predefinition mainly needs to record an attribute value.

Specifically, assuming that the factory actually has 3 types of tires suitable for 3 types of car models, with different attribute parameter values such as tire width, then 3 tire predefinitions can be created, corresponding to 3 types of tires respectively. The 3 tire predefinitions are as follows:

```
     Def_Tire_SportSedan1//Sports sedan tire
     {
     Tire width = 200;
     The percentage of tire thickness to tire width = 36;
     Rim diameter=18;
     Load coefficient =58;
     Speed identifier = "H";
     Is it good=true;
     } ID="D1";
     Def_Tire_SportCar1//Sports car tire
     {
     Tire width = 210;
     The percentage of tire thickness to tire width = 38;
     Rim diameter=19;
     Load coefficient = 60;
     Speed identifier="Z";
     Is it good=true;
     } ID="D2";
     Def_Tire_ExoticSportCar1//Special sports car tire
     {
     Tire width = 210;
     The percentage of tire thickness to tire width = 38;
     Rim diameter=19;
     Load coefficient=64;
     Speed identifier = "Y";
     Is it good=true;
     } ID="D3";
```

After creating the data model, assuming that the number of tires of three specifications will be produced in the factory are 10,000, 8,000, and 1,000, and the user creates real-time digital twinning objects of these tires while actually producing these tires, then 10,000 tires for sports cars are created based on the predefined Def_Tire_SportSedan (sports car); 8000 tires for sports cars are created based on the predefined Def_Tire_SportCar (sports car); 1000 tires for special sports cars are created based on the predefined Def_Tire_ExoticSportCar (special sports car).

The digital twinning object created by the user is created according to the predefinition. The initial value of the object comes from the predefinition. Therefore, for the objects created by different predefinitions, member values including a tire width, a percentage of tire thickness to tire width, a rim diameter, a load coefficient, a speed identifier, and whether it is good, are consistent with the predefined member values by default; the created digital twinning object has a time attribute TimePosition; the attribute value when created is the production time. It is assumed that the production time suitable for 10,000 tires of sports car is 2021-5-5 8:0:0, at the same time, the digital twinning object has spatial attributes, and its parent attribute (Parent) is used for recording which vehicle the tire is assembled on when it is assembled, that is, the space in which it is located.

Then the real-time object of one of the tires can be represented as follows when created:

```
     RealtimeObj_Tire_SportSedan5
     {
     Tire width = 200;
     The percentage of tire thickness to tire width = 36;
     Rim diameter=18;
     Load coefficient=58;
     Speed identifier = "H";
     Is it good=true;
     TimePosition=DateTimeParse("2021-5-5 8:0:0");
     Parent=0; //0 means not assembled
     } ID=5;
```

Assuming that after the tire production is completed, the quality inspection finds that some tires are unqualified, it needs to modify the good or bad members of the twinning real-time objects of these tires to false. Assuming that the modification time is 2021-5-7 8:0:0, then the time attribute TimePosition also needs to be modified to the change time of the object at the same time, i.e., 2021-5-7 8:0:0, as shown below:

```
     RealtimeObj_Tire_SportSedan4//Unqualified tires
     {
     Tire width = 200;
     The percentage of tire thickness to tire width = 36;
     Rim diameter=18;
     Load coefficient=58;
     Speed identifier = "H";
     Is it good=false;
     TimePosition=DateTimeParse("2021-5-7 8:0:0");
     Parent=0;
     } ID=4;
```

Qualified tires will be used in the assembly of the car. Assuming that the assembly time is 2021-5-8 8:0:0, the real-time object will change to:

```
     RealtimeObj_Tire_SportSedan5//After assembly of qualified tires
     {
     Tire width = 200;
     The percentage of tire thickness to tire width = 36;
     Rim diameter=18;
     Load coefficient=58;
     Speed identifier = "H";
     Is it good=false;
     TimePosition=DateTimeParse("2021-5-8 8:0:0");
     Parent=3476778912330022912; //Assuming 3476778912330022912 is the car object ID
     } ID=5;
```

A historical object of the tire can also be created. The historical object includes historical records. Taking the tire with ID 5 as an example, 2 historical records are added to record the state of the tire when it was created and assembled. The diagram is as follows:

```
     HistoryData1_Tire_SportSedan5// the first history record of tire 5
     {
     Tire width = 200;
     The percentage of tire thickness to tire width = 36;
     Rim diameter=18;
     Load coefficient=58;
     Speed identifier = "H";
     Is it good=true;
     TimePosition=DateTimeParse("2021-5-5 8:0:0");
     Parent=0;
     } ID=5;
     HistoryData2_Tire_SportSedan5// the second history record of tire 5
     {
     Tire width = 200;
     The percentage of tire thickness to tire width = 36;
     Rim diameter=18;
     Load coefficient=58;
     Speed identifier = "H";
     Is it good=false;
     TimePosition=DateTimeParse("2021-5-8 8:0:0");
     Parent=3476778912330022912;
     } ID=5;
```

Historical objects are automatically generated when the real-time object of the twinning changes. The two historical records of the tire with ID=5 do not need to be created by the user. The state of the real-time object when it is created and assembled will be automatically saved as the above two historical records.

The data model concept proposed in the embodiments of the present disclosure includes the structural model and the predefinition, which can solve the problem of being unable to distinguish between two or more models with the same structure but different parameter values during the modeling phase, and provide a basis for the construction of complex models.

Combined with the above embodiments, if there is no tire predefinition and there is only one tire model, the modeling stage cannot distinguish between 3 specifications of tires and can only build 3 tire models. This is because the differences between the 3 specifications are reflected in the attribute parameter values. It is not reflected in the attribute parameter structure. A model that only relies on one attribute parameter structure cannot be expressed.

Suppose a user needs to build a composite car model, such as a sports car model. Based on the present disclosure, the user can add 4 predefined sports car tires as sub-models of the sports car model to form a sports car model. The indication is as follows:

```
     sports car model
     Def_Tire_SportSedan1
     Def_Tire_SportSedan2
     Def_Tire_SportSedan3
     Def_Tire_SportSedan4
```

However, the related art cannot describe and distinguish models with the same structure and different values, let alone build a composite model similar to the above.

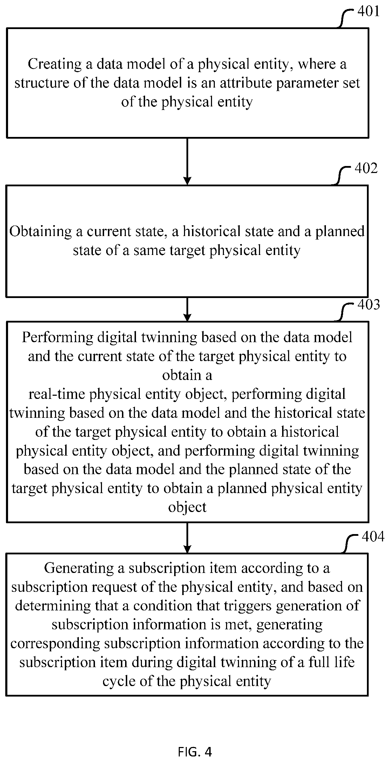

FIG. 4 is a flow chart of a physical entity subscription method provided by embodiments of the present disclosure. As shown in FIG. 4, the embodiments of the present disclosure further provide a physical entity subscription method, which includes the following steps.

Step 401: creating a data model of a physical entity, where a structure of the data model is an attribute parameter set of the physical entity.

Step 402: obtaining a current state, a historical state and a planned state of a same target physical entity.

Step 403: performing digital twinning based on the data model and the current state of the target physical entity to obtain a real-time physical entity object, performing digital twinning based on the data model and the historical state of the target physical entity to obtain a historical physical entity object, and performing digital twinning based on the data model and the planned state of the target physical entity to obtain a planned physical entity object.

Step 404: generating a subscription item according to a subscription request of the physical entity, and based on determining that a condition that triggers generation of subscription information is met, generating corresponding subscription information according to the subscription item during digital twinning of a full life cycle of the physical entity.

The data twinning process of the physical entity object in the above steps 401 to 403 refers to the description of the above embodiments, which will not be described again here.

After receiving a subscription request containing "a physical entity object identifier", the spatiotemporal database generates a subscription item, where the subscription item includes a physical entity object identifier and a filtering condition.

The spatiotemporal database is pre-established inside. The physical entity object identifier is associated with the subscription item of the predefined data initial value. The physical entity object identifier is associated with the subscription item of the predefined instantiated physical entity object. The physical entity object identifier is associated with the subscription item of data generated by the predefined instantiated physical entity object.

Specifically, when determining the condition that triggers the generation of the subscription information is met, generating corresponding subscription information according to the subscription item includes the following types.

1. Predefined creation, modification and deletion based on the model.

In the process of physical entity twin, when determining that the predefined data initial value is created, whether there is a subscription item corresponding to the physical entity object identifier corresponding to the predefined data initial value is queried. If the subscription item exists, the predefined creation event is published.

When the predefined data initial value is subsequently modified or deleted, the predefined modification event and the predefined deletion event will also be published accordingly.

As an optional embodiment, determining the condition that triggers the generation of the subscription information is met, generating corresponding subscription information according to the subscription item includes:
determining that the condition that triggers the generation of subscription information is met when at least one set of predefined data initial values corresponding to the structure of the data model is determined to be created, modified or deleted;
querying at least one set of predefined data initial values corresponding to the structure of the data model for data whose attribute parameters include a physical entity object identifier and satisfy the above filtering condition according to the physical entity object identifier and the filtering condition in the above subscription item to obtain the subscription information matching the subscription request.

2. Based on the above created predefined data initial value, the planned physical entity object is created, modified and deleted.

In the process of physical entity twin, when determining that the planned physical entity object is created, whether there is a subscription item corresponding to the physical entity object identifier corresponding to the planned physical entity object is queried. If the subscription item exists, the planned physical entity object creation event is published.

When the planned physical entity object is modified or deleted, the planned physical entity object modification event and the planned physical entity object deletion event will also be published accordingly.

As an optional embodiment, when determining that the condition that triggers the generation of subscription information is met, generating the corresponding subscription information according to the subscription item, includes:
determining the condition that triggers the generation of subscription information is met when a planned physical entity object is determined to be created, modified or deleted;
when attribute parameters of the planned physical entity object that is determined to be created, modified or deleted include a physical entity identifier in the subscription item, querying data, in the planned physical entity object that is determined to be created, modified or deleted, that satisfies the filtering condition in the subscription item to obtain the subscription information matching the subscription request.

3. Based on the above created planned physical entity object, the real-time physical entity object is created, modified and deleted.

In the process of physical entity twin, when determining that the real-time physical entity object instantiated by the planned physical entity object is created, whether there is a subscription item corresponding to the physical entity object identifier corresponding to the real-time physical entity object is queried. If the subscription item exists, the real-time physical entity object creation event is published.

When the real-time object is modified or deleted, the real-time physical entity object modification event and the real-time physical entity object deletion event will also be published accordingly.

As an optional embodiment, when determining that the condition that triggers the generation of subscription information is met, generating the corresponding subscription information according to the subscription item, includes:
determining that the condition that triggers the generation of subscription information is met when a real-time physical entity object instantiated by a planned physical entity object is determined to be created, or when a real-time physical entity object is determined to be deleted or modified;
when attribute parameters of the real-time physical entity object that is determined to be created, modified or deleted include a physical entity identifier in the subscription item, querying data, in the real-time physical entity object that is determined to be created, modified or deleted, that satisfies the filtering condition in the subscription item to obtain the subscription information matching the above subscription request.

4. The historical physical entity object is generated based on the real-time physical entity object created above.

When the real-time physical entity object is modified, historical data will be generated, that is, a historical physical entity object is generated. Whether there is a subscription item corresponding to the physical entity object identifier of the historical physical entity object is queried. If the subscription item exists, the event generated by the historical physical entity object is published.

As an optional embodiment, determining that the condition that triggers the generation of subscription information is met, generating the corresponding subscription information according to the subscription item, includes:
determining that the condition that triggers the generation of subscription information is met when a real-time physical entity object is determined to be modified to generate a historical physical entity object;
when attribute parameters of the generated historical physical entity object include a physical entity identifier in the subscription item, querying data, in the generated historical physical entity object, that satisfies the filtering condition in the subscription item to obtain the subscription information matching the subscription request.

After completing the physical entity subscription, the embodiments of the present disclosure further provide a physical entity query method, including:
receiving a physical entity query request, where the above physical entity query request includes a physical entity object identifier and a filtering field;
determining the subscription information obtained by the subscription item containing the above physical entity object identifier, filtering the determined subscription information according to the filtering field to obtain a query result.

Specifically, querying the physical entity includes the following steps.

First, the created predefined data initial value is queried based on the model.

After the model database receives a query request that only contains "physical entity object identifier and/or filtering condition", based on the physical entity object identifier and filtering condition, when querying the predefined data initial value instantiated by the model, querying is performed based on the predefined identifier of the physical entity data model.

Then, a multi-temporal query of the physical entity object is performed based on the predefined identifier of the above query.

After receiving a query request containing only "predefined identifier and/or filtering condition", the planned database queries the planned physical entity object instantiated by the predefined data initial value.

After receiving a query request containing only "predefined identifier and/or filtering condition", the real-time database queries the real-time physical entity object converted from the planned physical entity object instantiated by the predefined data initial value.

After receiving a query request containing only "predefined identifier and/or filtering condition", the historical database queries the historical physical entity object generated by the real-time physical entity object instantiated by the predefined data initial value.

Based on the same disclosed concept, the embodiments of the present disclosure further provide a digital twinning apparatus for the full life cycle of a physical entity. This apparatus is the apparatus in the method in the embodiments of the present disclosure, and the principle of solving the problem of the apparatus is the similar as that of the method, so the implementation of the apparatus can be referred to the implementation of the method, and repeated details will not be repeated.

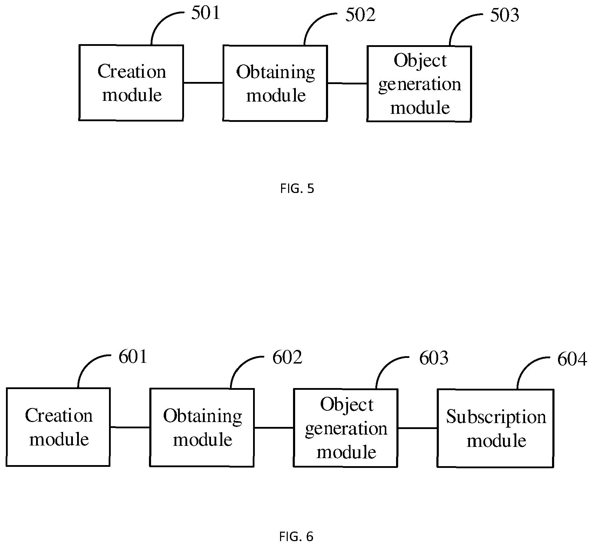

FIG. 5 is a schematic diagram of a digital twinning apparatus for the full life cycle of a physical entity provided by embodiments of the present disclosure. As shown in FIG. 5, the embodiments of the present disclosure provide a digital twinning apparatus for the full life cycle of a physical entity. The apparatus includes:
a creation module 501, configured to create a data model of the physical entity, where a structure of the above data model is an attribute parameter set of the physical entity;
an obtaining module 502, configured to obtain a current state, a historical state and a planned state of a same target physical entity;
an object generation module 503, configured to perform digital twinning based on the above-mentioned data model and the current state of the above-mentioned target physical entity to obtain a real-time physical entity object, perform digital twinning based on the above-mentioned data model and the historical state of the above-mentioned target physical entity to obtain a historical physical entity object and perform digital twinning based on the data model and the planned state of the target physical entity to obtain a planned physical entity object.

Optionally, the attribute parameter set of the above physical entity includes:
spatial attributes, used for recording a space of the physical entity.

Optionally, the above creation module 501 creates the data model of the physical entity, including:
obtaining the structure of the data model by determining the attribute parameter set of the physical entity, where attribute parameters in the attribute parameter set of the physical entity include an attribute name and a data type;
performing at least one attribute parameter initialization on the structure of the data model to obtain at least one set of predefined data initial values corresponding to the structure of the data model.

Optionally, the above-mentioned object generation module 503 performs digital twinning based on the above-mentioned data model and the current state of the above-mentioned target physical entity to obtain the real-time physical entity object, performs digital twinning based on the above-mentioned data model and the historical state of the above-mentioned target physical entity to obtain the historical physical entity object and performs digital twinning based on the data model and the planned state of the target physical entity to obtain the planned physical entity object, including:
determining a set of predefined data initial values corresponding to a target physical entity, and replacing the determined set of predefined data initial values with attribute parameter values corresponding to a current state of the target physical entity to obtain the above real-time physical entity object;
determining a set of predefined data initial values corresponding to a target physical entity, and replacing the determined set of predefined data initial values with attribute parameter values corresponding to a historical state of the target physical entity to obtain the above historical physical entity object;
determining a set of predefined data initial values corresponding to a target physical entity, and replacing the determined set of predefined data initial values with attribute parameter values corresponding to a planned state of the target physical entity to obtain the above planned physical entity object.

Optionally, the attribute parameter set of the above physical entity includes a time attribute.

The time attribute of the above-mentioned real-time physical entity object is used for recording the current moment when the physical entity changes or the latest moment when the physical entity changes.

The time attribute of the above historical physical entity object is used for recording every time the physical entity changes in history.

The time attribute of the above planned physical entity object is used for recording the moment when the physical entity plans to change and the duration of the change.

Optionally, the digital twinning device for the full life cycle of the physical entity provided in the embodiments of the present disclosure further includes an object record generation module, used for:
recording an attribute parameter value of the obtained real-time physical entity object to obtain a real-time physical entity object record corresponding to the physical entity;
recording an attribute parameter value of the obtained historical physical entity object to obtain a historical physical entity object record corresponding to the physical entity;
recording an attribute parameter values of the obtained planned physical entity object to obtain a planned physical entity object record corresponding to the physical entity.

Here, physical entity object identifiers of the real-time physical entity object record, the historical physical entity object record and the planned physical entity object record of the same physical entity are the same.

Optionally, the above-mentioned object record generation module is used for recording the attribute parameter values of the obtained historical physical entity object to obtain the historical physical entity object record corresponding to the physical entity, including:
determining that a current state of the above-mentioned target physical entity changes, obtaining a historical state of the target physical entity according to the changed state of the target physical entity, and determining and recording an attribute parameter value of the historical physical entity object to obtain a historical physical entity object record corresponding to the physical entity; or
determining and recording an attribute parameter value of a historical physical entity object according to a historical state of a target physical entity predefined by a user to obtain a historical physical entity object record corresponding to the physical entity.

Optionally, the above-mentioned object record generation module is used for recording the attribute parameter value of the obtained planned physical entity object to obtain the planned physical entity object record corresponding to the physical entity, including:
determining and recording an attribute parameter value of the planned physical entity object according to the planned state of the target physical entity predefined by the user to obtain a planned physical entity object record corresponding to the physical entity.

Optionally, the above object record generation module is further configured for:
after replacing the determined set of predefined data initial values with the attribute parameter values corresponding to the current state of the target physical entity, recording a set of attribute parameter values obtained after the replacement to obtain a real-time physical entity object record corresponding to the physical entity;
after replacing the determined set of predefined data initial values with the attribute parameter values corresponding to the historical state of the target physical entity, recording a set of attribute parameter values obtained after the replacement to obtain a historical physical entity object record corresponding to the physical entity;
after replacing the determined set of predefined data initial values with the attribute parameter values corresponding to the planned state of the target physical entity, recording a set of attribute parameter values obtained after the replacement to obtain a planned physical entity object record corresponding to the physical entity.

Here, physical entity object identifiers of the real-time physical entity object record, the historical physical entity object record, and the planned physical entity object record of the same physical entity are the same.

Optionally, the attribute parameter values corresponding to the historical state of the target physical entity are determined according to a current state of the target physical entity after the change, or according to a historical state of the target physical entity predefined by the user.

The attribute parameter values corresponding to the planned state of the target physical entity are determined according to a planned state of the target physical entity predefined by the user.

Optionally, the attribute parameter set of the above physical entity includes the following attribute parameters:
a physical entity data model identifier, used for uniquely identifying the data model corresponding to the physical entity;
a physical entity object identifier, used for uniquely identifying the corresponding physical entity;
a predefined identifier of a physical entity data model, used for uniquely identifying a set of predefined data initial values of a corresponding physical entity data model.

Optionally, the above spatial attributes further include at least one of the following attributes:
a location attribute, used for recording a spatial location where the physical entity is located;
a shape attribute, used for recording a shape of the physical entity.

Optionally, the above-mentioned spatial location is described as an offset of the above-mentioned physical entity relative to a spatial location of other associated physical entity, or as another object entity within a spatial location of other associated physical entity.

Based on the same disclosed concept, the embodiments of the present disclosure further provide a physical entity subscription device. Since this device is the device in the method in the embodiments of the present disclosure, and the principle of solving the problem of the device is similar to that of the method, the implementation of the device refers to the implementation of the method, and the repeated points will not be repeated.

FIG. 6 is a schematic diagram of a physical entity subscription device provided by embodiments of the present disclosure. As shown in FIG. 6, the embodiments of the present disclosure provide a physical entity subscription device, which includes:
a creation module 601, configured to create a data model of the physical entity, where a structure of the above data model is an attribute parameter set of the physical entity;
an obtaining module 602, configured to obtain a current state, a historical state and a planned state of a same target physical entity;
an object generation module 603, configured to perform digital twinning based on the above data model and the current state of the target physical entity to obtain a real-time physical entity object, perform a digital twinning based on the above data model and the historical state of the target physical entity to obtain a historical physical entity object, and perform digital twinning based on the data model and the planned state of the target physical entity to obtain a planned physical entity object;
a subscription module 604, configured to generate a subscription item according to a subscription request of the physical entity, and based on determining that a condition that triggers the generation of subscription information is met, generate corresponding subscription information according to the above subscription item during digital twinning of a full life cycle of the physical entity.

Optionally, the above-mentioned subscription module 604 is configured to generate the corresponding subscription information according to the above-mentioned subscription item in response to determining that the condition that triggers the generation of subscription information is met, including:
determining that the condition that triggers the generation of subscription information is met when at least one set of predefined data initial values corresponding to the structure of the data model is determined to be created, modified or deleted;
querying at least one set of predefined data initial values corresponding to the structure of the data mode for data whose attribute parameters include the above physical entity object identifier and satisfy the above filtering condition according to the physical entity object identifier and the filtering condition in the above subscription item to obtain the subscription information matching the subscription request.

Optionally, the above-mentioned subscription module 604 is configured to generate the corresponding subscription information according to the above-mentioned subscription item in response to determining that the condition that triggers the generation of subscription information is met, including:
determining the condition that triggers the generation of subscription information is met when a planned physical entity object is determined to be created, modified or deleted;
when the attribute parameters of the planned physical entity object that is determined to be created, modified or deleted include a physical entity identifier in the subscription item, querying data, in the planned physical entity object that is determined to be created, modified or deleted, that satisfies the filtering condition in the subscription item to obtain the subscription information matching the subscription request.

Optionally, the above-mentioned subscription module 604 is configured to generate the corresponding subscription information according to the above-mentioned subscription item in response to determining that the condition that triggers the generation of subscription information is met, including:
determining that the condition that triggers the generation of subscription information is met when a real-time physical entity object instantiated by a planned physical entity object is determined to be created, or when a real-time physical entity object is determined to be deleted or modified;
when attribute parameters of the real-time physical entity object that is determined to be created, modified or deleted include a physical entity identifier in the subscription item, querying data, in the real-time physical entity object that is determined to be created, modified or deleted, that satisfies the filtering condition in the subscription item to obtain the subscription information matching the subscription request.

Optionally, the above-mentioned subscription module 604 is configured to generate the corresponding subscription information according to the above-mentioned subscription item in response to determining that the condition that triggers the generation of subscription information is met, including:
determining that the condition that triggers the generation of subscription information is met when a real-time physical entity object is determined to be modified to generate a historical physical entity object;
when attribute parameters of the generated historical physical entity object include a physical entity identifier in the subscription item, querying data, in the generated historical physical entity object, that satisfies the filtering condition in the subscription item to obtain the subscription information matching the subscription request.

Optionally, the device further includes a query module configured for:
receiving a physical entity query request, where the above physical entity query request includes a physical entity object identifier and a filtering field;
determining the subscription information obtained by the subscription item containing the above physical entity object identifier, filtering the determined subscription information according to the above filtering field to obtain a query result.

The following is a description of a digital twinning method for the full life cycle of an event provided by the embodiments of the present disclosure when the thing is an event.

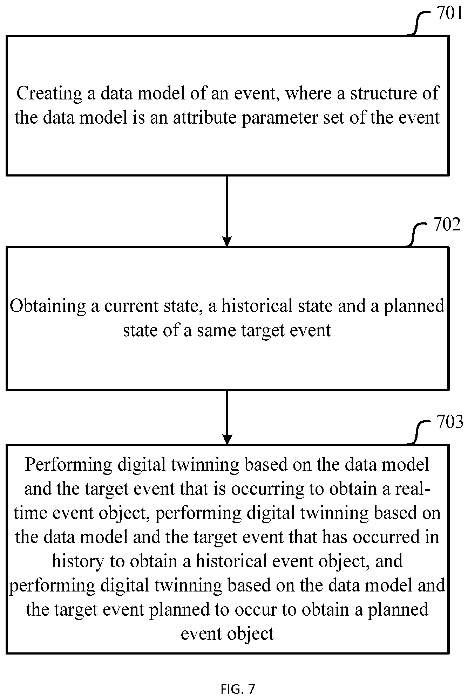

FIG. 7 is a schematic flow chart of a digital twinning method for the full life cycle of an event provided by embodiments of the present disclosure. As shown in FIG. 7, the embodiments of the present disclosure provide a digital twinning method for the full life cycle of an event, including the following steps.

Step 701: creating a data model of the event, where a structure of the data model is an attribute parameter set of the event.

A data model is created for a target event. The target event can include a current state, a historical state, and a planned state based on time attributes. Specifically, digital twins can be performed based on different states of the target event. When creating the data model of the target event, the structure of the data model of the target event can be obtained by determining the attribute parameter set of the target event. The attribute parameters in the attribute parameter set of the target event include an attribute name and a data type.

In a possible embodiment, the creating the data model of the event includes:
obtaining the structure of the data model by determining the attribute parameter set of the event, where attribute parameters in the attribute parameter set of the event include an attribute name and a data type;
performing at least one attribute parameter initialization on the structure of the data model to obtain at least one set of predefined data initial values corresponding to the structure of the data model.

Predefined steps can operate according to the user's needs, or no predefined operation is performed.

Step 702: obtaining a current state, a historical state and a planned state of the same target event.

In order to perform a full-cycle digital twinning of the target event, the state of the target event is divided into the current state, historical state and planned state, where the state refers to a specific value of each attribute parameter in the attribute parameter set of the target event at the corresponding moment.

Step 703: performing digital twinning based on the data model and the target event that is occurring to obtain a real-time event object, performing digital twinning based on the data model and the target event that has occurred in history to obtain a historical event object, and performing digital twinning based on the data model and the target event planned to occur to obtain a planned event object.

Digital twins are performed on different states of the target event to obtain event objects corresponding to the target event, including real-time event objects, historical event objects, and planned event objects. Here, the real-time event object represents the event that is occurring; the historical event object represents the event that has occurred in history; and the planned event object represents the event that is planned to occur.

The embodiments provided by the present disclosure are to digitally twinning the full life cycle of the target event to obtain an event object. Therefore, the target event is divided into a target event that is occurring, a historical target event that has occurred in history, and a planned target event planned to occur.

In a possible embodiment, performing digital twinning based on the data model and the target event that is occurring to obtain a real-time event object, includes:
determining a set of predefined initial data values corresponding to the classification of the target event that is occurring, and replacing the determined set of predefined data initial values with attribute parameter values of the target event that is occurring to obtain the real-time event object.

Performing digital twinning based on the data model and the target event that has occurred in history to obtain a historical event object, includes:
determining a set of predefined initial data values corresponding to the classification of the target event that has occurred in history, and replacing the determined set of predefined data initial values with attribute parameter values of the target event that has occurred in history to obtain the historical event object.

Performing digital twinning based on the data model and the target event planned to occur to obtain the planned event object, includes:
determining a set of predefined data initial values corresponding to the classification of a target event planned to occur, and replacing the determined set of predefined data initial values with attribute parameter values of the target event planned to occur to obtain a planned event object.

The method provided by the embodiments of the present disclosure builds the same data model for the target event and defines one or more sets of initial values for the same data model. This solves the problem in the existing modeling stage that it is impossible to distinguish between the same structure but different parameter values so that multiple models need to be built.

It should be noted that, as described in step 703 above, predefined operations may be performed according to the user's needs or no predefined operations are performed. If no predefined operations are performed, the data model based on the target event can be directly used to obtain real-time event objects, historical event objects, and planned event objects.

The present disclosure provides a digital twinning method for the life cycle of the event. By creating a data model of the event, performing digital twinning based on the data model and the target event that is occurring to obtain a real-time event object, performing digital twinning based on the data model and the target event that has occurred in history to obtain a historical event object, and performing digital twinning based on the data model and the target event planned to occur to obtain a planned event object, data modeling of the full life cycle of the event is realized.

The attribute parameters of the event in the above step 701 specifically include at least one of the following:
a time attribute, where the time attribute of the real-time event object is used for recording a start time and duration of the event; the time attribute of the historical event object is used for recording the start time and end time of the event, or is used for recording the start time and duration of the event; the time attribute of the planned event object is used for recording the start time and end time of the event, or is used for recording the start time and duration of the event.
an event data model identifier, used for uniquely identifying the data model of the corresponding event;
an event object identifier, used for uniquely identifying the corresponding event;
a predefined identifier of the event data model, used for uniquely identifying a set of predefined data initial values of the corresponding event data model.

Spatial attributes are used for recording the space where the event occurs, including at least one of a spatial location and a spatial range. If the target event has spatial attributes, the spatial attributes of the target event can be another physical object, organization or person.

For example, if the target event is "reading discussion meeting", its spatial attribute can be the meeting location, the organization participating in the meeting, or the people participating in the meeting.

Parent attribute: the event object has a unique parent attribute, which establishes a parent-child relationship between the event and its parent event. By establishing the parent-child relationship, the relationship between events can be described more clearly. For example, an order has multiple child orders.

After the event object is obtained by performing digital twinning based on the data model and the target event in step 703 above, the parameter values of the event object can also be recorded to obtain the corresponding event object record. Specifically, the following implementation methods can be used:
event object records are used to describe event objects, specifically including at least one of the following.

### (1) Real-time event object records.

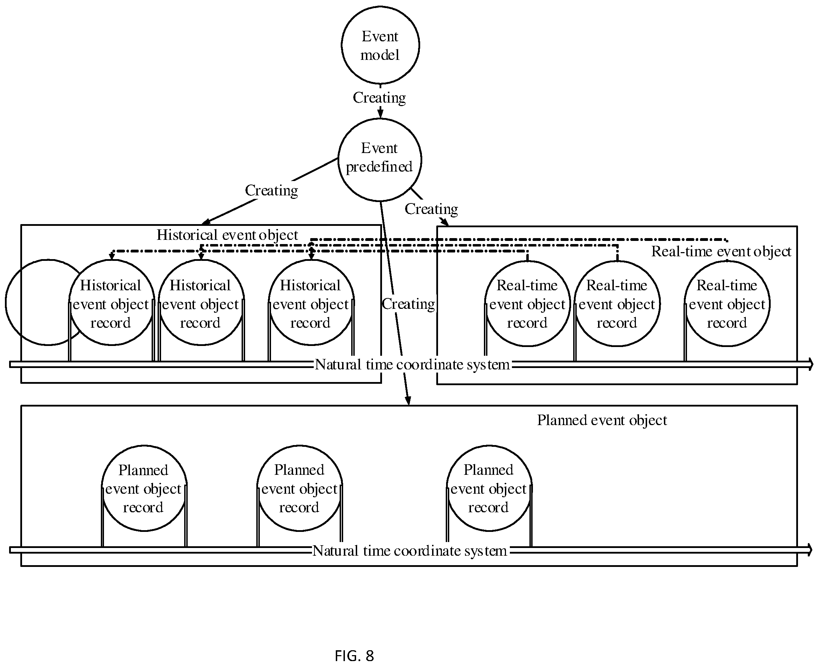

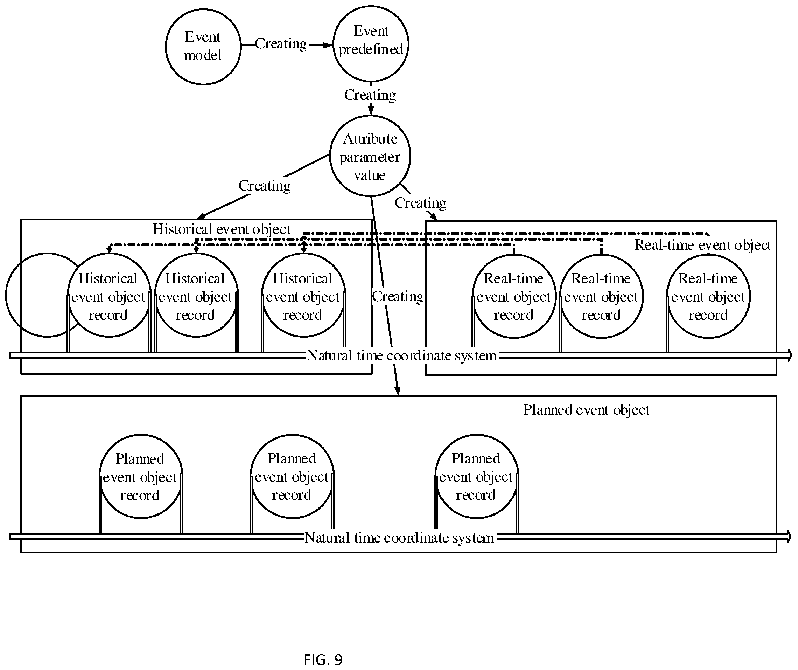

In a possible embodiment, the attribute parameter values of the obtained real-time event object are recorded to obtain a real-time event object record corresponding to the target event, including:
as shown in FIG. 8, according to the attribute parameter values of the target event that occurs in real time predefined by the user, obtaining a real-time event object record corresponding to the target event, where each real-time event object record corresponds to an event that is occurring; or
as shown in FIG. 9, using the attribute parameter values corresponding to the target event that is occurring to replace the determined set of predefined data initial values, recording a set of attribute parameter values after the replacement, to obtain a real-time event object record corresponding to the target event.

It should be noted that real-time event object records and historical event object records with the same event object record identifier will not exist at the same time. That is, historical event object records and real-time event object records for the same target event will not be recorded at the same time. If one thing is over, it will no longer be happening, and what is happening will not be over.

### (2) Historical event object records.

In a possible embodiment, recording an attribute parameter value(s) of the obtained historical event object to obtain a historical event object record corresponding to the target event, includes:
in response to determining that the target event that is occurring ends, recording the attribute parameter value(s) of the target event to obtain the historical event object record of the target event; or
as shown in FIG. 8, obtaining a historical event object record of the target event based on the attribute parameter value of the target event that has occurred in history predefined by the user; or
as shown in FIG. 9, using the attribute parameter values corresponding to the target event that has occurred in history to replace the determined set of predefined data initial values, recording the set of attribute parameter values obtained after the replacement to obtain the historical event object record corresponding to the target event.

Here, the attribute parameter values corresponding to the target event that has occurred in history are determined based on the attribute parameter values at the end of the target event that is occurring, or based on the attribute parameter values predefined by the user.

Each historical event object record corresponds to an event that has occurred in history. After the real-time event object record is completed, it can be automatically saved as a historical event object record, indicating that the event that is occurring has ended and become history.

### (3) Planned event object records.

In a possible embodiment, recording the attribute parameter value(s) of the obtained planned event object to obtain a planned event object record corresponding to the target event, including:
as shown in FIG. 8, obtaining a planned event object record corresponding to the target event according to the attribute parameter value of the target event that is planned to occur predefined by the user, where each planned event object record corresponds to an event that has occurred in history; or
as shown in FIG. 9, using the attribute parameter values corresponding to the target event that is planned to occur to replace the determined set of predefined data initial values, recording the set of attribute parameter values obtained after the replacement to obtain the planned event object record corresponding to the target event.

Here, the attribute parameter value corresponding to the target event that is planned to occur is determined based on the attribute parameter value predefined by the user.

In addition, the event object identifiers of the real-time event object record, the historical event object record, and the planned event object record of the same target event are the same.

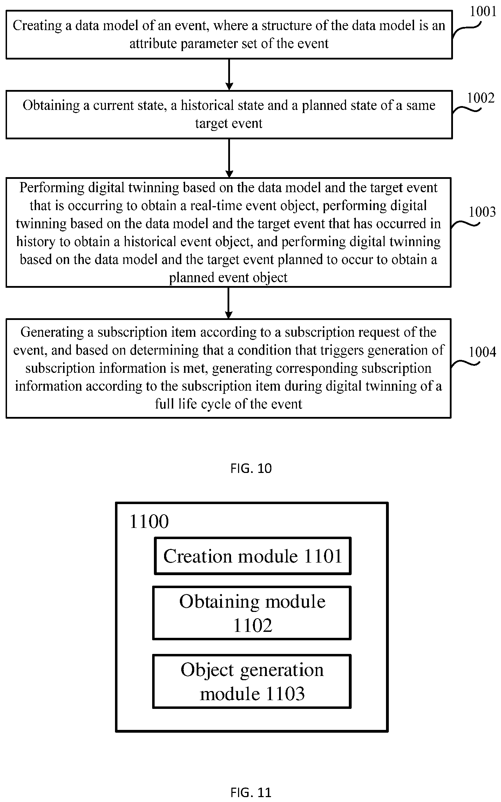

Based on the same inventive concept, embodiments of the present disclosure provide an event subscription method, as shown in FIG. 10. The method includes the following steps.

Step 1001: creating a data model of an event, where a structure of the data model is an attribute parameter set of the event.

Step 1002: obtaining a current state, a historical state and a planned state of a same target event.

Step 1003: performing digital twinning based on the data model and the target event that is occurring to obtain a real-time event object, performing digital twinning based on the data model and the target event that has occurred in history to obtain a historical event object, and performing digital twinning based on the data model and the target event planned to occur to obtain a planned event object.

For details of the above steps 1001 to 1003, please refer to the foregoing embodiments, and will not be described again here.

Step 1004: generating a subscription item according to a subscription request of the event, and based on determining that a condition that triggers generation of subscription information is met, generating corresponding subscription information according to the subscription item during digital twinning of a full life cycle of the event.

After receiving the subscription request containing the "event object identifier", the spatiotemporal database generates a subscription item(s), where the subscription item includes an event object identifier and a filtering condition.

The spatiotemporal database is pre-established internally. The event object identifier is associated with the subscription item of the predefined data initial value. The event object identifier is associated with the subscription item of the predefined instantiated event object. The event object identifier is associated with the subscription item of the data generated by the predefined instantiated event object.

In the process of digital twinning of the full life cycle of an event, the event object record is subscribed according to the subscription request of the event, and the condition(s) that trigger(s) the generation of subscription information include(s) at least one of the following.
(1) When it is determined that at least a set of predefined data initial values corresponding to the structure of the data model is created, the condition that triggers the generation of subscription information is met.

During the process of event twinning, it is found that when creating an event object, whether there is a subscription item corresponding to the object identifier of the event is queried. If the subscription item exists, the creation event of the event object is published.

In a possible embodiment, when it is determined that the condition that triggers the generation of subscription information is met, generating corresponding subscription information based on the above subscription item, includes:
determining that the condition that triggers the generation of subscription information is met when at least one set of predefined data initial values corresponding to the structure of the data model is determined to created;
querying at least one set of predefined data initial values corresponding to the structure of the data model for data whose attribute parameters include an event object identifier and satisfy a filtering condition according to the event object identifier and the filtering condition in the subscription item to obtain the subscription information matching the subscription request.

(2) When a planned event object is determined to be created, modified or deleted, the condition that triggers the generation of subscription information is met.

In the process of event twinning, it is found that when a planned event object is created, whether there is a subscription item corresponding to the event object identifier of the planned event object is queried. If the subscription item exists, the planned event object creation event is published.

When the planned event object is modified or deleted, the planned event object modification event and the planned event object deletion event are published.

In a possible embodiment, determining that the condition that triggers the generation of subscription information is met, generating the corresponding subscription information according to the subscription item, includes:
determining the condition that triggers the generation of subscription information is met when a planned event object is determined to be created, modified or deleted;
when attribute parameters of the planned event object that is determined to be created, modified or deleted include an event object identifier in the subscription item, querying data, in the planned event object that is determined to be created, modified or deleted, that satisfies the filtering condition in the subscription item to obtain the subscription information matching the subscription request.

(3) When the real-time event object is determined to be created, modified or deleted based on the created planned event object, the condition that triggers the generation of subscription information is met.

In the process of event twinning, it is found that when a real-time event object instantiated by a planned event object is created, whether there is a subscription item corresponding to the event object identifier of the real-time event object is queried. If the subscription item exists, the real-time event object creation event is published.

When the real-time object is modified or deleted, the real-time event object modification event and the real-time event object deletion event are published.

In a possible embodiment, when determining that the condition that triggers the generation of subscription information is met, generating the corresponding subscription information according to the subscription item, includes:
determining the condition that triggers the generation of subscription information is met when a real-time event object based on the created planned event object is determined to be created, modified or deleted;
after determining that the condition that triggers the generation of subscription information is met, when time attributes of the event object that is determined to be created, modified or deleted belong to a time range in the subscription item, querying data, in the event object that is determined to be created, modified or deleted, that satisfies the filtering condition in the subscription item to obtain the subscription information matching the subscription request.

(4) When it is determined that the historical event objects generated based on the end of real-time events increase, the condition that triggers the generation of subscription information is met.

When the real-time event object is modified, historical data will be generated, that is, a historical event object will be generated. Whether there is a subscription item corresponding to the event object identifier of the historical event object is queried. If the subscription item exists, the historical event object creation event is published.

In a possible embodiment, generating corresponding subscription information based on the subscription item when it is determined that a condition that triggers the generation of subscription information is met, further includes:
when it is determined that the historical event objects generated based on the end of real-time events increase, satisfying the condition that triggers the generation of subscription information;
when attribute parameters of the added historical event object includes an event object identifier in the subscription item, querying data, in the generated historical event object, that satisfies the filtering condition in the subscription item to obtain the subscription information matching the subscription request.

(5) When an event object is determined to be created, modified or deleted, the condition that triggers the generation of subscription information is met.

During the process of event twinning, it is found that when creating an event object, whether there is a subscription item corresponding to the event object identifier of the event object is queried. If the subscription item exists, the event object creation event is published.

When the event object is modified or deleted, the event object modification event and the event object deletion event are published.

In a possible embodiment, generating corresponding subscription information according to the subscription item in response to determining that the condition that triggers the generation of subscription information is met, includes:
determining that the condition that triggers the generation of subscription information is met when the event object is determined to be created, modified or deleted, where the event object includes a planned event object, a real-time event object and a historical event object;
when the time attributes of the event object that is determined to be created, modified or deleted belong to the time range in the subscription item, querying the data in the event object that is determined to be created, modified or deleted, that meets the filtering condition in the corresponding subscription item to obtain the subscription information matching the subscription request.

In a possible embodiment, determining that the condition that triggers the generation of subscription information is met, generating the corresponding subscription information according to the subscription item, includes:
determining that the condition that triggers the generation of subscription information is met when an event object is determined to be created, modified or deleted, where the event object includes a planned event object, a real-time event object and a historical event object;
when a generation entity to which the event object that is determined to be created, modified or deleted belongs is consistent with an entity identifier in the subscription item, and a spatial range of the entity to which the entity belongs is consistent with a spatial range in the subscription item, querying data, in the event object that is determined to be created, modified or deleted, that satisfies the filtering condition in the subscription item to obtain the subscription information matching the subscription request.

Based on the same inventive concept, the embodiments of the present disclosure provide a digital twinning apparatus for the full life cycle of an event. As shown in FIG. 11, the device 1100 includes:
a creation module 1101, configured to create a data model of the event, where a structure of the data model is an attribute parameter set of the event;
an obtaining module 1102, configured to obtain a current state, a historical state and a planned state of the same target event;
an object generation module 1103, configured to perform digital twinning based on the data model and the target event that is occurring to obtain a real-time event object, perform digital twinning based on the data model and the target event that has occurred in history to obtain a historical event object, and perform digital twinning based on the data model and the target event planned to occur to obtain a planned event object.

In a possible embodiment, the creation module 1101 is configured to create the data model of the event, including:
obtaining the structure of the data model by determining the attribute parameter set of the event, where attribute parameters in the attribute parameter set of the event include an attribute name and a data type;
performing at least one attribute parameter initialization on the structure of the data model to obtain at least one set of predefined data initial values corresponding to the structure of the data model.

In a possible embodiment, the object generation module 1103 is configured to perform digital twinning based on the data model and the target event that is occurring to obtain a real-time event object, perform digital twinning based on the data model and the target event that has occurred in history to obtain a historical event object, and perform digital twinning based on the data model and the target event planned to occur to obtain a planned event object, including:
determining a set of predefined data initial values corresponding to the classification of a target event that is occurring, and replacing the determined set of predefined data initial values with attribute parameter values of the target event that is occurring to obtain a real-time event object;
determining a set of predefined data initial values corresponding to the classification of a target event that has occurred in history, and replacing the determined set of predefined data initial values with attribute parameter values of the target event that has occurred in history to obtain a historical event object;
determining a set of predefined data initial values corresponding to the classification of a target event planned to occur, and replacing the determined set of predefined data initial values with attribute parameter values of the target event planned to occur to obtain a planned event object.

In a possible embodiment, the creation module 1101 is used to create the attribute parameter set of the event, and the attribute parameter set of the event includes a time attribute, where:
the time attribute of the real-time event object is used for recording the start time and duration of the event;
the time attribute of the historical event object is used for recording the start time and end time of the event, or is used for recording the start time and duration of the event;
the time attribute of the planned event object is used for recording the start time and end time of the event, or is used for recording the start time and duration of the event.

In a possible embodiment, a recording module is used for:
recording an attribute parameter value of the obtained real-time event object to obtain a real-time event object record corresponding to the target event;
recording an attribute parameter value of the obtained historical event object to obtain a historical event object record corresponding to the target event;
recording an attribute parameter value of the obtained planned event object to obtain a planned event object record corresponding to the target event.

Here, event object identifiers of the real-time event object record, the historical event object record, and the planned event object record of the same target event are the same.

In a possible embodiment, the recording module is used for recording the attribute parameter value of the obtained historical event object to obtain the historical event object record corresponding to the target event, including:
in response to determining that the target event that is occurring ends, recording an attribute parameter value of a target event to obtain a historical event record of the target event; or
obtaining a historical event object record of the target event according to an attribute parameter value of the target event that has occurred in history predefined by the user.

In a possible embodiment, the recording module is used for recording the attribute parameter value of the obtained planned event object to obtain the planned event object record corresponding to the target event, including:
obtaining a planned event object record corresponding to a target event according to an attribute parameter value of the target event planned to occur predefined by the user.

In a possible embodiment, the creation module 1101 is configured for:
after replacing the determined set of predefined data initial values with the attribute parameter values of the target event that is occurring, recording a set of attribute parameter values obtained after the replacement to obtain a real-time event object record corresponding to the target event;
after replacing the determined set of predefined data initial values with the attribute parameter values of the target event that has occurred in history, recording a set of attribute parameter values obtained after the replacement to obtain a historical event object record corresponding to the target event;
after replacing the determined set of predefined data initial values with the attribute parameter values of the target event planned to occur, recording a set of attribute parameter values obtained after the replacement to obtain a planned event object record corresponding to the target event.

In a possible embodiment, a determination module is configured to determine the attribute parameter value corresponding to the target event that has occurred in history based on the attribute parameter value at the end of the target event that is occurring, or based on the attribute parameter value predefined by the user.

The attribute parameter value corresponding to the target event planned to occur is determined based on the attribute parameter value predefined by the user.

In a possible embodiment, the recording module is configured to determine that a historical event object record and a real-time event object record of the same target event will not be recorded at the same time.

In a possible embodiment, the creation module 1101 is used to create the attribute parameter set of the event, and the attribute parameter set includes the following attribute parameters:
an event data model identifier, used for uniquely identifying the data model of the corresponding event;
an event object identifier, used for uniquely identifying the corresponding event;
a predefined identifier of the event data model, used for uniquely identifying a set of predefined data initial values of a corresponding event data model.

In a possible embodiment, the creation module 1101 is used to create the attribute parameter set of the event, and the attribute parameter set further includes:
a spatial attribute, used for recording the space where the event occurs.

In a possible embodiment, the creation module 1101 is used to create the spatial attribute, and the spatial attribute includes at least one of a spatial location and a spatial range.

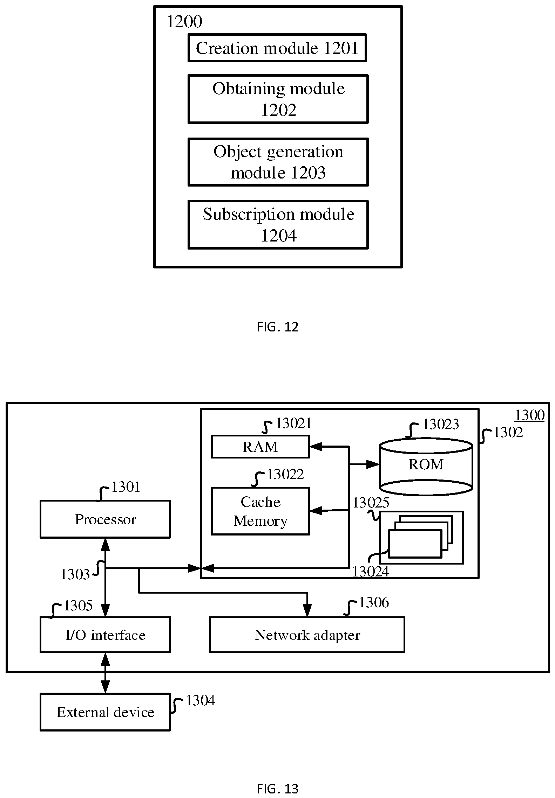

Based on the same inventive concept, an embodiment of the present disclosure provides an event subscription device. As shown in FIG. 12, the device 1200 includes:
a creation module 1201, configured to create a data model of the event, where a structure of the data model is an attribute parameter set of the event;
an obtaining module 1202, configured to obtain a current state, a historical state and a planned state of a same target event;
an object generation module 1203, configured to perform digital twinning based on the data model and the target event that is occurring to obtain a real-time event object, perform digital twinning based on the data model and the target event that has occurred in history to obtain a historical event object, and perform digital twinning based on the data model and the target event planned to occur, to obtain a planned event object;
a subscription module 1204, configured to generate a subscription item according to a subscription request of the event, and based on determining that a condition that triggers generation of subscription information is met, generate corresponding subscription information according to the subscription item during digital twinning of a full life cycle of the event.

In a possible embodiment, the subscription module 1204 is configured to generate corresponding subscription information according to the subscription item when determining that the condition that triggers the generation of subscription information is met, including:
determining that the condition that triggers the generation of subscription information is met when at least one set of predefined data initial values corresponding to the structure of the data model is created;
querying at least one set of predefined data initial values corresponding to the structure of the data model for data whose attribute parameters include an event object identifier and satisfy a filtering condition according to the event object identifier and the filtering condition in the subscription item to obtain the subscription information matching the subscription request.

In a possible embodiment, the subscription module 1204 is configured to generate the corresponding subscription information according to the subscription item when determining that the condition that triggers the generation of subscription information is met, including:
determining that the condition that triggers the generation of subscription information is met when at least one set of predefined data initial values corresponding to the structure of the data model is determined to created;
querying at least one set of predefined data initial values corresponding to the structure of the data model for data whose attribute parameters include an event object identifier and satisfy a filtering condition according to the event object identifier and the filtering condition in the subscription item to obtain the subscription information matching the subscription request.

In a possible embodiment, the subscription module 1204 is configured to generate corresponding subscription information according to the subscription item when determining that the condition that triggers the generation of subscription information is met, including:
determining the condition that triggers the generation of subscription information is met when the planned event object is determined to be created, modified or deleted;
when attribute parameters of the planned event object that is determined to be created, modified or deleted include an event object identifier in the subscription item, querying data, in the planned event object that is determined to be created, modified or deleted, that satisfies the filtering condition in the subscription item to obtain the subscription information matching the subscription request.

In a possible embodiment, the subscription module 1204 is configured to generate corresponding subscription information according to the subscription item when determining that the condition that triggers the generation of subscription information is met, further including:
determining that the condition that triggers the generation of subscription information is met when the real-time event object based on the created planned event object is determined to be created, modified or deleted;
when attribute parameters of the real-time event object that is determined to be created, modified or deleted include an event object identifier in the subscription item, querying data, in the real-time event object that is determined to be created, modified or deleted, that satisfies the filtering condition in the subscription item to obtain the subscription information matching the subscription request.

In a possible embodiment, the subscription module 1204 is configured to generate corresponding subscription information according to the subscription item when determining that the condition that triggers the generation of subscription information is met, further including:
determining that the condition that triggers the generation of subscription information is met when a historical event object generated based on an end of a real-time event is determined to be added;
when attribute parameters of the added historical event object include an event object identifier in the subscription item, querying data, in the generated historical event object, that satisfies the filtering condition in the subscription item to obtain the subscription information matching the subscription request.

In a possible embodiment, the subscription module 1204 is configured to generate corresponding subscription information according to the subscription item when determining that the condition that triggers the generation of subscription information is met, including:
determining that the condition that triggers the generation of subscription information is met when an event object is determined to be created, modified or deleted, where the event object includes a planned event object, a real-time event object and a historical event object;
when time attributes of the event object that is determined to be created, modified or deleted belong to a time range in the subscription item, querying data, in the event object that is determined to be created, modified or deleted, that satisfies the filtering condition in the subscription item to obtain the subscription information matching the subscription request.

Based on the same disclosed concept, the embodiments of the present disclosure further provide a digital twinning apparatus for the full life cycle of a thing. Since this apparatus is the apparatus in the method in the embodiments of the present disclosure, and the principle of solving the problem of this apparatus is the similar as that of the method, so the implementation of the apparatus can be referred to the implementation of the method, and repeated details will not be repeated.

Those skilled in the art can understand that various aspects of the present disclosure can be implemented as systems, methods or program products. Therefore, various aspects of the present disclosure can be specifically implemented in the following forms, namely: a complete hardware implementation, a complete software implementation (including firmware, microcode, etc.), or a combination of hardware and software implementations, which may be collectively referred to herein as "circuit", "module" or "system".

In some possible embodiments, a device or an apparatus according to the present disclosure may include at least one processor and at least one memory. Wherein, the memory stores program codes, and when the program codes are executed by the processor, the program codes cause the processor to perform the steps in the digital twinning method for the full life cycle of the physical entity according to the various exemplary embodiments of the present disclosure described above, or perform the steps in the digital twinning method for the full life cycle of the event according to various exemplary embodiments of the present disclosure described above.

A device or an apparatus 1300 according to the embodiments of the present disclosure is described below with reference to FIG. 13. The device or apparatus 1300 shown in FIG. 13 is only an embodiment and should not impose any restrictions on the functions and usage scope of the embodiments of the present disclosure.

As shown in FIG. 13, the device or apparatus 1300 is in the form of a general device. The components of the device or apparatus 1300 may include, but are not limited to: the above-mentioned at least one processor 1301, the above-mentioned at least one memory 1302, and a bus 1303 connecting different system components (including the memory 1302 and the processor 1301), where the memory stores program coded. When the program codes are executed by the processor, the program codes cause the processor to perform the following steps:
creating a data model of the thing, where a structure of the data model is an attribute parameter set of the thing;
obtaining a current state, a historical state and a planned state of a same target thing;
performing digital twinning based on the data model and the current state of the target thing to obtain a real-time thing object, performing digital twinning based on the data model and the historical state of the target thing to obtain a historical thing object, and performing digital twinning based on the data model and the planned state of the target thing to obtain a planned thing object.

The bus 1303 represents one or more of several types of bus structures, including a memory bus or memory controller, a peripheral bus, a processor, or a local bus using any of a variety of bus structures.

The memory 1302 may include readable media in the form of volatile memory, such as random access memory (RAM) 13021 and/or cache memory 13022, and may further include read only memory (ROM) 13023.

The memory 1302 may also include a program/utility tool 13025 having a set of (at least one) program modules 13024, the program module 13024 including, but not limited to: an operating system, one or more application programs, other program modules, and program data. Each of the embodiments, or some combination thereof, may include the implementation of a network environment.

The device or apparatus 1300 may also communicate with one or more external devices 1304 (e.g., keyboard, pointing device, etc.), with one or more devices that enable a user to interact with device 1300, and/or with one or more devices that enable device 1300 to interact with any device (such as a router, modem, etc.) that communicates with one or more other devices. This communication may occur through an input/output (I/O) interface 1305. Further, the device 1300 may communicate with one or more networks (e.g., a local area network (LAN), a wide area network (WAN), and/or a public network, such as the Internet) through a network adapter(s) 1306. As shown, the network adapter 1306 communicates with other modules for the device 1300 over the bus 1303. It should be understood that, although not shown in the figures, other hardware and/or software modules may be used in conjunction with the device 1300, including but not limited to: microcode, device drivers, redundant processors, external disk drive arrays, RAID systems, tape drives, and data backup storage system, etc.

Based on the same disclosed concept, the embodiments of the present disclosure further provide a thing subscription device. Since this device is the device in the method in the embodiments of the present disclosure, and the principle of solving the problem of this device is similar to that of this method, the implementation of the device refers to the implementation of the method, and repeated details will not be repeated.

Those skilled in the art can understand that various aspects of the present disclosure can be implemented as systems, methods or program products. Therefore, various aspects of the present disclosure can be specifically implemented in the following forms, namely: a complete hardware implementation, a complete software implementation (including firmware, microcode, etc.), or a combination of hardware and software implementations, which may be collectively referred to herein as "circuit", "module" or "system".

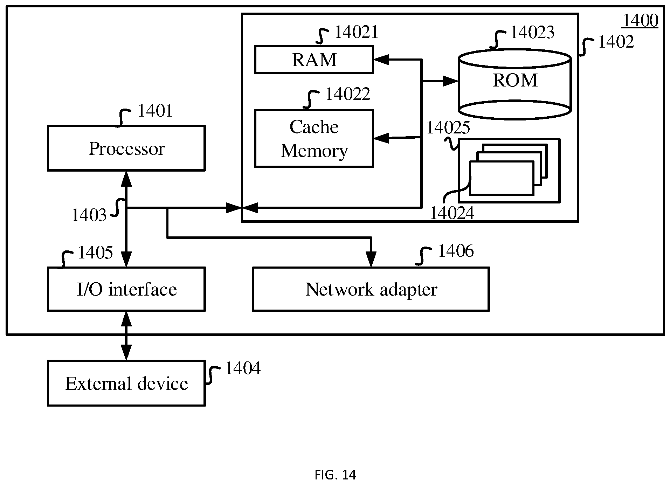

The device or apparatus 1400 according to the embodiments of the present disclosure is described below with reference to FIG. 14. The device 1400 shown in FIG. 14 is only an embodiment and should not bring any limitations to the functions and usage scope of the embodiments of the present disclosure.

As shown in FIG. 14, the device 1400 is represented by a general device. The components of the device 1400 may include, but are not limited to: the above-mentioned at least one processor 1401, the above-mentioned at least one memory 1402, and a bus 1403 connecting different system components (including the memory 1402 and the processor 1401), where the memory stores program codes. When the program codes are executed by the processor, the program codes cause the processor to execute each step of the above-mentioned digital twinning method.

Although the preferred embodiments of the present disclosure are described, those skilled in the art will be able to make additional changes and modifications to these embodiments once the basic inventive concepts are understood. Therefore, it is intended that the appended claims be construed to include the preferred embodiments and all changes and modifications that fall within the scope of the present disclosure. Obviously, those skilled in the art can make various changes and modifications to the present disclosure without departing from the spirit and scope of the present disclosure. In this way, if these modifications and variations of the present disclosure fall within the scope of the claims of the present disclosure and equivalent technologies, the present disclosure is also intended to include these modifications and variations.

## Claims

1. A digital twinning method for a full life cycle of a thing, comprising:
creating a data model of the thing, wherein a structure of the data model is an attribute parameter set of the thing;
obtaining a current state, a historical state and a planned state of a same target thing; and
performing digital twinning based on the data model and the current state of the target thing to obtain a real-time thing object, performing digital twinning based on the data model and the historical state of the target thing to obtain a historical thing object, and performing digital twinning based on the data model and the planned state of the target thing to obtain a planned thing object.

2. The method according to claim 1, wherein the thing is a physical entity or an event.

3. The method according to claim 2, wherein the attribute parameter set of the thing comprises:
spatial attributes configured for recording a space of the physical entity or a space where the event occurs.

4. The method according to claim 1, wherein the creating the data model of the thing comprises:
obtaining the structure of the data model by determining the attribute parameter set of the thing, wherein attribute parameters in the attribute parameter set of the thing comprise an attribute name and a data type;
performing at least one attribute parameter initialization on the structure of the data model to obtain at least one set of predefined data initial values corresponding to the structure of the data model.

5. The method according to claim 4, wherein when the thing is a physical entity, the performing digital twinning based on the data model and the current state of the target thing to obtain the real-time thing object, performing digital twinning based on the data model and the historical state of the target thing to obtain the historical thing object, and performing digital twinning based on the data model and the planned state of the target thing to obtain the planned thing object, comprise:
determining a set of predefined data initial values corresponding to a target physical entity, and replacing the determined set of predefined data initial values with attribute parameter values corresponding to a current state of the target physical entity to obtain a real-time physical entity object;
determining a set of predefined data initial values corresponding to a target physical entity, and replacing the determined set of predefined data initial values with attribute parameter values corresponding to a historical state of the target physical entity to obtain a historical physical entity object;
determining a set of predefined data initial values corresponding to a target physical entity, and replacing the determined set of predefined data initial values with attribute parameter values corresponding to a planned state of the target physical entity to obtain a planned physical entity object.

6. The method according to claim 4, wherein when the thing is an event, the performing digital twinning based on the data model and the current state of the target thing to obtain the real-time thing object, performing digital twinning based on the data model and the historical state of the target thing to obtain the historical thing object, and performing digital twinning based on the data model and the planned state of the target thing to obtain the planned thing object, comprise:
determining a set of predefined data initial values corresponding to classification of a target event that is occurring, and replacing the determined set of predefined data initial values with attribute parameter values of the target event that is occurring to obtain a real-time event object;
determining a set of predefined data initial values corresponding to classification of a target event that has occurred in history, and replacing the determined set of predefined data initial values with attribute parameter values of the target event that has occurred in history to obtain a historical event object;
determining a set of predefined data initial values corresponding to classification of a target event planned to occur, and replacing the determined set of predefined data initial values with attribute parameter values of the target event planned to occur to obtain a planned event object.

7. The method according to any one of claims 1 to 3, wherein when the thing is a physical entity, the attribute parameter set of the thing comprises a time attribute, wherein,
the time attribute of a real-time physical entity object is used for recording a current moment when the physical entity changes or a latest moment when the physical entity changes;
the time attribute of a historical physical entity object is used for recording every time the physical entity changes in history;
the time attribute of a planned physical entity object is used for recording a moment when the physical entity plans to change and a duration of the change.

8. The method according to any one of claims 1 to 3, wherein when the thing is an event, the attribute parameter set of the thing comprises a time attribute, wherein,
the time attribute of a real-time event object is used for recording a start time of the event and a duration of the event;
the time attribute of a historical event object is used for recording the start time of the event and an end time of the event, or is used for recording the start time of the event and the duration of the event;
the time attribute of a planned event object is used for recording the start time of the event and the end time of the event, or is used for recording the start time of the event and the duration of the event.

9. The method according to claim 4, further comprising:
recording an attribute parameter value of the obtained real-time thing object to obtain a real-time thing object record of a corresponding thing;
recording an attribute parameter value of the obtained historical thing object to obtain a historical thing object record of a corresponding thing;
recording an attribute parameter value of the obtained planned thing object to obtain a planned thing object record of a corresponding thing;
wherein a thing object identifier of the real-time thing object record, a thing object identifier of the historical thing object record, and a thing object identifier of the planned thing object record of the same thing are the same.

10. The method according to claim 9, wherein when the thing is a physical entity, the recording the attribute parameter value of the obtained historical thing object to obtain the historical thing object record of the corresponding thing comprises:
based on determining that a current state of a target physical entity changes, obtaining a historical state of the target physical entity according to a changed state of the target physical entity, and determining and recording an attribute parameter value of a historical physical entity object to obtain a historical physical entity object record corresponding to the physical entity; or
determining and recording an attribute parameter value of a historical physical entity object according to a historical state of a target physical entity predefined by a user to obtain a historical physical entity object record corresponding to the physical entity.

11. The method according to claim 9, wherein when the thing is an event, the recording the attribute parameter value of the obtained historical thing object to obtain the historical thing object record of the corresponding thing comprises:
based on determining that a target event that is occurring ends, recording an attribute parameter value of the target event to obtain a historical event record of the target event; or
obtaining a historical event object record of a target event according to an attribute parameter value of the target event that has occurred in history predefined by a user.

12. The method according to claim 9, wherein when the thing is a physical entity, the recording the attribute parameter value of the obtained planned thing object to obtain the planned thing object record of the corresponding thing comprises:
determining and recording an attribute parameter value of a planned physical entity object according to a planned state of a target physical entity predefined by a user to obtain a planned physical entity object record corresponding to the physical entity.

13. The method according to claim 9, wherein when the thing is an event, the recording the attribute parameter value of the obtained planned thing object to obtain the planned thing object record of the corresponding thing comprises:
obtaining a planned event object record corresponding to a target event according to an attribute parameter value of the target event planned to occur predefined by a user.

14. The method according to claim 5, wherein when the thing is a physical entity, the method further comprises:
after replacing the determined set of predefined data initial values with the attribute parameter values corresponding to the current state of the target physical entity, recording a set of attribute parameter values obtained after the replacement to obtain a real-time physical entity object record corresponding to the physical entity;
after replacing the determined set of predefined data initial values with the attribute parameter values corresponding to the historical state of the target physical entity, recording a set of attribute parameter values obtained after the replacement to obtain a historical physical entity object record corresponding to the physical entity;
after replacing the determined set of predefined data initial values with the attribute parameter values corresponding to the planned state of the target physical entity, recording a set of attribute parameter values obtained after the replacement to obtain a planned physical entity object record corresponding to the physical entity;
wherein a physical entity object identifier of the real-time physical entity object record, a physical entity object identifier of the historical physical entity object record, and a physical entity object identifier of the planned physical entity object record of the same physical entity are the same.

15. The method according to claim 6, wherein when the thing is an event, the method further comprises:
after replacing the determined set of predefined data initial values with the attribute parameter values of the target event that is occurring, recording a set of attribute parameter values obtained after the replacement to obtain a real-time event object record corresponding to the target event;
after replacing the determined set of predefined data initial values with the attribute parameter values of the target event that has occurred in history, recording a set of attribute parameter values obtained after the replacement to obtain a historical event object record corresponding to the target event;
after replacing the determined set of predefined data initial values with the attribute parameter values of the target event planned to occur, recording a set of attribute parameter values obtained after the replacement to obtain a planned event object record corresponding to the target event.

16. The method according to claim 14, further comprising:
determining the attribute parameter values corresponding to the historical state of the target physical entity according to a current state of the target physical entity after the change, or according to a historical state of the target physical entity predefined by a user;
determining the attribute parameter values corresponding to the planned state of the target physical entity according to a planned state of the target physical entity predefined by the user.

17. The method according to claim 15, further comprising:
determining the attribute parameter values of the target event that has occurred in history according to attribute parameter values at the end of the target event that is occurring, or according to attribute parameter values predefined by a user;
determining the attribute parameter values of the target event planned to occur according to the attribute parameter values predefined by the user.

18. The method according to any one of claims 10 to 17, wherein the attribute parameter set of the thing comprises the following attribute parameters:
a thing data model identifier, used for uniquely identifying the data model of the corresponding thing;
a thing object identifier, used for uniquely identifying the corresponding thing;
a predefined identifier of a thing data model, used for uniquely identifying a set of predefined data initial values of a corresponding thing data model.

19. The method according to claim 3, wherein when the thing is the physical entity, the spatial attributes further comprise at least one of the following attributes:
a location attribute, used for recording a spatial location where the physical entity is located;
a shape attribute, used for recording a shape of the physical entity.

20. The method according to claim 3, wherein when the thing is the event, the spatial attributes comprise at least one of a spatial location and a spatial range.

21. The method according to claim 19, wherein,
the spatial location is described as an offset of the physical entity relative to a spatial location of other associated physical entity, or as another object entity within a spatial location of other associated physical entity.

22. The method according to claim 9 or 15, wherein when the thing is an event, a historical event object record and a real-time event object record of a same target event are not recorded at the same time.

23. A physical entity subscription method, comprising:
creating a data model of a thing, wherein a structure of the data model is an attribute parameter set of the thing;
obtaining a current state, a historical state and a planned state of a same target thing;
performing digital twinning based on the data model and the current state of the target thing to obtain a real-time thing object, performing digital twinning based on the data model and the historical state of the target thing to obtain a historical thing object, and performing digital twinning based on the data model and the planned state of the target thing to obtain a planned thing object; and
generating a subscription item according to a subscription request for the thing, and based on determining that a condition that triggers generation of subscription information is met, generating corresponding subscription information according to the subscription item during digital twinning of a full life cycle of the thing.

24. The method according to claim 23, wherein the thing is a physical entity or an event.

25. The method according to claim 23, wherein the based on determining that the condition that triggers the generation of subscription information is met, generating the corresponding subscription information according to the subscription item, comprises:
determining that the condition that triggers the generation of subscription information is met when at least one set of predefined data initial values corresponding to the structure of the data model is determined to be created, modified or deleted;
querying at least one set of predefined data initial values corresponding to the structure of the data model for data whose attribute parameters comprise a thing object identifier and satisfy a filtering condition according to the thing object identifier and the filtering condition in the subscription item to obtain the subscription information matching the subscription request.

26. The method according to claim 25, wherein the based on determining that the condition that triggers the generation of subscription information is met, generating the corresponding subscription information according to the subscription item, comprises:
determining the condition that triggers the generation of subscription information is met when a planned thing object is determined to be created, modified or deleted;
when attribute parameters of the planned thing object that is determined to be created, modified or deleted comprise a thing identifier in the subscription item, querying data, in the planned thing object that is determined to be created, modified or deleted, that satisfies the filtering condition in the subscription item to obtain the subscription information matching the subscription request.

27. The method according to claim 25, wherein the based on determining that the condition that triggers the generation of subscription information is met, generating the corresponding subscription information according to the subscription item, comprises:
determining that the condition that triggers the generation of subscription information is met when a real-time thing object instantiated by a planned thing object is determined to be created, or when the real-time thing object is determined to be deleted or modified;
when attribute parameters of the real-time thing object that is determined to be created, modified or deleted comprise a thing identifier in the subscription item, querying data, in the real-time thing object that is determined to be created, modified or deleted, that satisfies the filtering condition in the subscription item to obtain the subscription information matching the subscription request.

28. The method according to claim 25, wherein when the thing is a physical entity, the based on determining that the condition that triggers the generation of subscription information is met, generating the corresponding subscription information according to the subscription item, comprises:
determining that the condition that triggers the generation of subscription information is met when a real-time physical entity object is determined to be modified to generate a historical physical entity object;
when attribute parameters of the generated historical physical entity object comprise a physical entity identifier in the subscription item, querying data, in the generated historical physical entity object, that satisfies the filtering condition in the subscription item to obtain the subscription information matching the subscription request.

29. The method according to claim 25, wherein when the thing is an event, the based on determining that the condition that triggers the generation of subscription information is met, generating the corresponding subscription information according to the subscription item, comprises:
determining that the condition that triggers the generation of subscription information is met when a historical event object generated based on an end of a real-time event is determined to be added;
when attribute parameters of the added historical event object comprise an event object identifier in the subscription item, querying data, in the generated historical event object, that satisfies the filtering condition in the subscription item to obtain the subscription information matching the subscription request.

30. The method according to claim 23 or 24, wherein when the thing is an event, the based on determining that the condition that triggers the generation of subscription information is met, generating the corresponding subscription information according to the subscription item, comprises:
determining that the condition that triggers the generation of subscription information is met when an event object is determined to be created, modified or deleted, wherein the event object comprises a planned event object, a real-time event object and a historical event object;
when time attributes of the event object that is determined to be created, modified or deleted belong to a time range in the subscription item, querying data, in the event object that is determined to be created, modified or deleted, that satisfies the filtering condition in the subscription item to obtain the subscription information matching the subscription request.

31. The method according to claim 23 or 24, wherein when the thing is an event, the based on determining that the condition that triggers the generation of subscription information is met, generating the corresponding subscription information according to the subscription item, comprises:
determining that the condition that triggers the generation of subscription information is met when an event object is determined to be created, modified or deleted, wherein the event object comprises a planned event object, a real-time event object and a historical event object;
when a generation entity to which the event object that is determined to be created, modified or deleted belongs is consistent with an entity identifier in the subscription item, and a spatial range of the generation entity to which the event object that is determined to be created, modified or deleted belongs is consistent with a spatial range in the subscription item, querying data, in the event object that is determined to be created, modified or deleted, that satisfies the filtering condition in the subscription item to obtain the subscription information matching the subscription request.

32. The method according to any one of claims 24 to 28, wherein when the thing is the physical entity, the method further comprises:
receiving a physical entity query request, wherein the physical entity query request comprises a physical entity object identifier and a filtering field;
determining the subscription information obtained by the subscription item containing the physical entity object identifier, and filtering the determined subscription information according to the filtering field to obtain a query result.

33. A digital twinning apparatus for a full life cycle of a thing, comprising:
a creation module, configured to create a data model of the thing, wherein a structure of the data model is an attribute parameter set of the thing;
an obtaining module, configured to obtain a current state, a historical state and a planned state of a same target thing; and
an object generation module, configured to perform digital twinning based on the data model and the current state of the target thing to obtain a real-time thing object, perform digital twinning based on the data model and the historical state of the target thing to obtain a historical thing object, and perform digital twinning based on the data model and the planned state of the target thing to obtain a planned thing object.

34. A thing subscription apparatus, comprising:
a creation module, configured to create a data model of the thing, wherein a structure of the data model is an attribute parameter set of the thing;
an obtaining module, configured to obtain a current state, a historical state and a planned state of a same target thing;
an object generation module, configured to perform digital twinning based on the data model and the current state of the target thing to obtain a real-time thing object, perform digital twinning based on the data model and the historical state of the target thing to obtain a historical thing object, and perform digital twinning based on the data model and the planned state of the target thing to obtain a planned thing object; and
a subscription module, configured to generate a subscription item according to a subscription request for the thing, and based on determining that a condition that triggers generation of subscription information is met, generate corresponding subscription information according to the subscription item during digital twinning of a full life cycle of the thing.

35. A digital twinning device for a full life cycle of a thing, comprising at least one processor; and a memory in communication connection with the at least one processor; wherein the memory stores instructions executed by the at least one processor, and the instructions are executed by the at least one processor to cause the at least one processor to perform the method according to any one of claims 1 to 22.

36. A thing subscription device, comprising at least one processor; and a memory in communication connection with the at least one processor; wherein the memory stores instructions executed by the at least one processor, and the instructions are executed by the at least one processor to cause the at least one processor to perform the method according to any one of claims 23 to 32.

37. A computer storage medium, storing computer programs, wherein the computer programs are configured to cause a computer to execute the method according to any one of claims 1 to 32.
